# EUROPEAN PATENT SPECIFICATION

(11) **EP 4 362 113 B1**
(45) Date of publication and mention of the grant of the patent: **29.04.2026**
(21) Application number: 22827601.0
(22) Date of filing: 22.06.2022
(51) Int. Cl.: H10H 20/851, H10K 59/32

(54) **QUANTUM DOT COMPLEX, THREE-DIMENSIONAL DISPLAY ELEMENT, AND PROCESSING METHOD FOR QUANTUM DOT COMPLEX**
QUANTENPUNKTKOMPLEX, DREIDIMENSIONALES ANZEIGEELEMENT UND VERARBEITUNGSVERFAHREN FÜR QUANTENPUNKTKOMPLEX
COMPLEXE DE POINTS QUANTIQUES, ÉLÉMENT D'AFFICHAGE TRIDIMENSIONNEL ET PROCÉDÉ DE TRAITEMENT POUR COMPLEXE DE POINTS QUANTIQUES

(30) Priority: 23.06.2021 CN 202110701334
(43) Date of publication of application: 01.05.2024
(73) Proprietor: Anhui Easpeed Technology Co., Ltd., Hefei, Anhui 230088 (CN)
(72) Inventor: ZHANG, Liangliang, Shanghai 200000 (CN); HAN, Chengfei, Shanghai 200000 (CN)
(74) Representative: Arnold & Siedsma
(86) International application number: PCT/CN2022/100379
(87) International publication number: WO 2022/268109

(56) References cited:
- CN-A- 102 098 822
- CN-A- 112 802 947
- CN-A- 113 363 361
- JP-A- 2015 165 611
- KR-A- 20120 087 039
- KR-A- 20130 045 506
- KR-A- 20130 045 506
- US-A1- 2008 230 750
- US-A1- 2017 179 087
- US-A1- 2020 066 810

## Description

### PRIORITY INFORMATION

This application claims priority to Chinese Patent Application No. 202110701334.1 filed on June 23, 2021.

### FIELD

The present disclosure relates to the field of display technologies, and more particularly, to a quantum dot complex, a three-dimensional display element, and a process for the quantum dot complex.

### BACKGROUND

The existing solid-state volumetric three-dimensional display technologies, such as a three-dimensional display technology based on an up-conversion material and a three-dimensional display technology of liquid crystal lamination, have their respective shortcomings. The former has low brightness and poor contrast, and the latter has low longitudinal resolution and a single viewing angle. US20170179087A1 discloses an array-type double-side light-emitting device, a manufacturing method thereof and a double-side display device. KR1020120087039A discloses a light emitting device. US2020066810A1 discloses an electronic display including a first plurality of hexagon-shaped pixels and a second plurality of hexagon-shaped pixels that are coplanar with the first plurality of hexagon-shaped pixels.

### SUMMARY

The present disclosure aims to solve at least one of the technical problems existing in the prior art. To this end, an object of the present disclosure is to provide a a processing method for a three-dimensional display element in accordance with claim 1 and a three-dimensional display element in accordance with claim 10.

According to embodiments of a first aspect of the present disclosure, provided is a processing method for a three-dimensional display element. The processing method includes: sequentially providing a first transparent conductive layer, coating a quantum dot layer, and providing a second transparent conductive layer, on a side of a transparent substrate to form a quantum dot unit, where processing the quantum dot unit comprises: coating a first photoresist layer at a side of the transparent substrate; exposing and developing to retain a part of the first photoresist layer to form a first residue portion; plating the first transparent conductive layer at an exposure and development side of the transparent substrate; peeling the first residue portion to form a first protrusion on the first transparent conductive layer, where the first protrusion is located at a side of a peeling region, and is configured to be connected to a first electrode; coating the quantum dot layer at a side where the first transparent conductive layer is located; coating a second photoresist layer; exposing and developing to retain a part of the second photoresist layer to form a second residue portion, where the second residue portion and the first residue portion are arranged close to an edge of the transparent substrate; plating the second transparent conductive layer at the exposure and development side of the transparent substrate; peeling the second residual portion to form a second protrusion on the second transparent conductive layer, where the second protrusion is located at a side of the second residual portion, and is configured to be connected to a second electrode, and where the first protrusion is offset from the second protrusion; sequentially laminating and bonding a plurality of quantum dot units in a thickness direction; obtaining a quantum dot complex by trimming the bonded quantum dot units; providing the first electrode and the second electrode outside the quantum dot complex, where the first electrode is electrically connected to the first transparent conductive layer of each quantum dot unit of the plurality of quantum dot units, and where the second electrode is electrically connected to the second transparent conductive layer of each quantum dot unit of the plurality of quantum dot units; and attaching a circuit board to a side of the quantum dot complex, and electrically connecting the circuit board to the first transparent conductive layer and the second transparent conductive layer of each quantum dot unit of the plurality of quantum dot units by the first electrode and the second electrode.

The processing method proposed in the present disclosure can significantly improve uniformity of a light-emitting surface in each layer of a bulk material for three-dimensional display, light-emitting contrast, material transparency, depth resolution, and increase a viewing angle of a three-dimensional image, and the like.

In some embodiments, said sequentially laminating and bonding the plurality of quantum dot units in a thickness direction includes: providing a spacer on at least one side of each of the plurality of quantum dot units, in which the spacer is a transparent polymer material member, a resin member, an optical glass member, or an optical crystal member; laminating the plurality of quantum dot units to form a lamination body, in which adjacent ones of the plurality of quantum dot units are spaced apart from each other by the spacer to form a gap for accommodating an adhesive; sealing two opposite side surfaces of the lamination body, and using another two opposite side surfaces of the lamination body as an adhesive introducing surface and an adhesive discharging surface; and injecting the adhesive to introduce the adhesive from the adhesive introducing surface and fill the gap, to form a layer of cured adhesive containing the spacer between the adjacent quantum dot units.

In some embodiments, the spacer has a height ranging from 1 µm to 500 µm. A distance between adjacent spacers ranges from 0.1 mm to 5 mm. An error on the heights of a plurality of spacers is smaller than or equal to 2 µm.

In some embodiments, a distance between adjacent spacers ranges from 5 µm to 20 mm. The spacer is selectable from one of silicon dioxide microsphere, polystyrene microsphere, and polymethyl methacrylate microsphere. The spacer has a spherical diameter ranging from 1 µm to 200 µm. An error on consistency of the diameter is smaller than 10%.

In some embodiments, the processing method further includes, prior to sealing the two opposite side surfaces of the lamination body or curing the adhesive: adjusting parallelism and planeness of the lamination body to control an error on each of the parallelism and the planeness within ± 5 µm.

In some embodiments, the lamination body is sealed by using a liquid sealant or a solid sealant. The liquid sealant is an epoxy resin or an acrylic resin, and the solid sealant is a rubber plate or a silicone adhesive. The liquid sealant has viscosity greater than 20000 cps, and is hardened through normal-temperature natural hardening, heating hardening, or ultraviolet irradiation hardening. The hardened liquid sealant has shore hardness ranging from 20 A to 70 A.

In some embodiments, the adhesive is defoamed before being injected. The adhesive has viscosity smaller than 500 cps. The adhesive is an epoxy resin or an acrylic resin. The cured adhesive has a volume shrinkage rate smaller than 1.1%, shore hardness ranging from 60 D to 80 D, and a refractive index same as a refractive index of the transparent substrate.

In some embodiments, the adhesive is injected through one of a first gravity injection, a second gravity injection, a first pressure injection, a second pressure injection, and a vacuum injection. The first gravity injection includes: placing the adhesive introducing surface of the lamination body in an adhesive pool of a gravity adhesive feeding device; connecting sealingly the gravity adhesive feeding device and the adhesive introducing surface through a sealing material or a sealing tool; placing the lamination body and the adhesive feeding device into a vacuum chamber of a vacuum device, filling the gap with the adhesive through gravity of the adhesive and a capillary of the adhesive; closing the vacuum device in response to observing the adhesive uniformly seeps at all positions of the adhesive discharging surface; and completing the injection of the adhesive. The second gravity injection includes: placing the adhesive introducing surface of the lamination body in an adhesive pool of a gravity adhesive feeding device; connecting sealingly the gravity adhesive feeding device and the adhesive introducing surface through a sealing material or a sealing tool; connecting a vacuum device at the adhesive discharging surface to wrap the entire adhesive discharging surface of the lamination body; isolating the adhesive discharging surface from an external environment through the sealing material or the sealing tool; setting an absolute vacuum degree of the vacuum device to be smaller than 10 kpa; closing the vacuum device in response to observing the adhesive uniformly seeps at all positions of the adhesive discharging surface; and completing the injection of the adhesive. The first pressure injection includes: placing the adhesive introducing surface of the lamination body in an adhesive of a pressure adhesive feeding device; connecting sealingly the pressure adhesive feeding device and the adhesive introducing surface through a sealing material or a sealing tool; applying a mechanical pressure to allow the gap to be full of the adhesive; monitoring an adjustment pressure by a pressure sensor mounted at the pressure adhesive feeding device to control an adhesive feeding speed; closing a pressure applying device in response to observing the adhesive uniformly seeps at all positions of the adhesive discharging surface; and completing the injection of the adhesive. The second pressure injection includes: placing the adhesive introducing surface of the lamination body in an adhesive of a pressure adhesive feeding device; connecting sealingly the pressure adhesive feeding device and the adhesive introducing surface through a sealing material or a sealing tool; applying an atmospheric pressure to allow the gap to be full of the adhesive; monitoring an adjustment air pressure by an air flow valve mounted at the pressure adhesive feeding device to control an adhesive feeding speed; closing a pressure applying device in response to observing the adhesive uniformly seeps at all positions of the adhesive discharging surface; and completing the injection of the adhesive. The vacuum injection includes: immersing the adhesive introducing surface of the lamination body in an adhesive pool containing the adhesive to liquid-seal the entire adhesive introducing surface by the adhesive; connecting a vacuum device at the adhesive discharging surface to wrap the entire adhesive discharging surface of the lamination body by the vacuum device; isolating the adhesive discharging surface from an external environment through a sealing material or a sealing tool; setting an absolute vacuum degree of the vacuum device to be smaller than 10 kpa; closing the vacuum device in response to observing the adhesive uniformly seeps at all positions of the adhesive discharging surface; and and completing the injection of the adhesive.

In some embodiments, said sequentially laminating and bonding the plurality of quantum dot units in a thickness direction includes: placing, subsequent to a first one of the plurality of quantum dot units being coated with the adhesive, a second one of the plurality of quantum dot units on the adhesive for bonding, repeating this processing method to form a laminated structure; and adjusting parallelism and flatness of the laminated structure prior to curing the laminated structure.

In some embodiments, the adhesive preferably has viscosity smaller than 1000 cps. The adhesive is an epoxy resin or an acrylic resin. The cured adhesive has a volume shrinkage rate smaller than 1.1% and shore hardness ranging from 60D to 80D.

According to embodiments of a second aspect of the present disclosure, provided is a three-dimensional display element, including a quantum dot complex. The quantum dot complex includes: a plurality of quantum dot units sequentially laminated and bonded to each other in a thickness direction, where each quantum dot unit of the plurality of quantum dot units comprises: a first protrusion formed on the first transparent conductive layer and a second protrusion on the second transparent conductive layer, the first protrusion being configured to be connected to a first electrode, and the second protrusion being configured to be connected to a second electrode, and the first protrusion being offset from the second protrusion; and a circuit board electrically connected to the first transparent conductive layer and the second transparent conductive layer of each quantum dot unit by the first electrode and the second electrode, respectively. Each of the plurality of quantum dot units includes a transparent substrate, a first transparent conductive layer, a second transparent conductive layer, and a quantum dot layer. In each quantum dot unit, the first transparent conductive layer, the quantum dot layer and the second transparent conductive layer are located at a side of the transparent substrate and sequentially arranged away from the transparent substrate. One of the first transparent conductive layer and the second transparent conductive layer is a P-type semiconductor, and another one of the first transparent conductive layer and the second transparent conductive layer is an N-type semiconductor. The quantum dot layer, the first transparent conductive layer, and the second transparent conductive layer of a quantum dot unit where the first transparent conductive layer is located or of a quantum dot unit adjacent to the quantum dot unit where the first transparent conductive layer is located are formed as a PN junction. The quantum dot complex has a surface formed as a laser incident surface; and in a lamination direction of the quantum dot units, the greater a distance from the laser incident surface, the greater a thickness of the quantum dot unit.

In some embodiments, the quantum dot layer has a thickness ranging from 0.05 µm to 10 µm; the transparent substrate has a thickness ranging from 0.1 mm to 0.5 mm; an error of parallelism and planeness of each of an upper smooth surface and a lower smooth surface of the transparent substrate is smaller than or equal to ± 2 µm; and a length a and a width b of the transparent substrate satisfy 1 mm≤a≤500 mm, and 1 mm≤b≤500 mm.

In some embodiments, a quantum dot layer of each quantum dot unit is configured to emit light in one color when being irradiated; or every three adjacent quantum dot units are defined as a color adjustment group. Quantum dot layers of three quantum dot units in each color adjustment group are configured to respectively emit red light, green light, and blue light when being irradiated.

Aiming at the problems existing in the existing solid-state volumetric three-dimensional display technology, the patent focuses on addressing problems from five aspects: ∘,1 the uniformity of the light-emitting surface, ∘,2 high material transparency, ∘,3 high depth resolution, ∘,4 achieving viewing of the image at 360°, and ∘,5 achieving full-color large-format three-dimensional display.

Additional aspects and advantages of the present disclosure will be provided at least in part in the following description, or will become apparent at least in part from the following description, or can be learned from practicing of the present disclosure.

### BRIEF DESCRIPTION OF THE DRAWINGS

The above and/or additional aspects and advantages of the present disclosure will become apparent and readily appreciated from the following description of the embodiments in conjunction with the accompanying drawings, in which:
FIG. 1 is a schematic diagram of a process for a quantum dot complex according to an embodiment of the present disclosure.
FIG. 2 is a schematic diagram of a processing method for a three-dimensional display element according to an embodiment of the present disclosure.
FIG. 3 is a schematic diagram of a processing method for a three-dimensional display element according to a specific embodiment of the present disclosure.
FIG. 4 is a process flow diagram of processing a quantum dot complex in a lamination manner according to an embodiment of the present disclosure.
FIG. 5 is a schematic diagram of a quantum dot complex according to an embodiment of the present disclosure.
FIG. 6 is a schematic diagram of split of a quantum dot complex according to an embodiment of the present disclosure.
FIG. 7 is a schematic diagram of arrangement of a spacer of a quantum dot complex according to an embodiment of the present disclosure.
FIG. 8 is a schematic diagram of arrangement of a spacer of a quantum dot complex according to another embodiment of the present disclosure.
FIG. 9 is a schematic diagram of arrangement of a spacer of a quantum dot complex according to yet another embodiment of the present disclosure.
FIG. 10 is a schematic diagram of arrangement of a quantum dot unit and a spacer of a quantum dot complex according to an embodiment of the present disclosure.
FIG. 11 is a schematic diagram of applying a pressure to a quantum dot unit and a spacer of a quantum dot complex according to an embodiment of the present disclosure.
FIG. 12 is a schematic diagram of arranging a sealant by a quantum dot complex according to an embodiment of the present disclosure.
FIG. 13 to FIG. 17 are schematic diagrams of an adhesive injection manner according to various embodiments of the present disclosure.
FIG. 18 is a schematic diagram of a display element.
FIG. 19 to FIG. 21 are schematic diagrams of a quantum dot complex bonded in a lamination manner according to an embodiment of the present disclosure.

### Reference Numerals:

quantum dot complex 100, electrode 20,
quantum dot unit 10, transparent substrate 11, first transparent conductive layer 12, quantum dot layer 13, second transparent conductive layer 14.
spacer 20, sealant 30, rigid plate body 40,
adhesive pool 51, bonding glue a, vacuum chamber 52, adhesive 60, seal 70.

### DETAILED DESCRIPTION

Embodiments of the present disclosure are described in detail below, and the embodiments described with reference to the drawings are exemplary. The embodiments of the present disclosure are described in detail below.

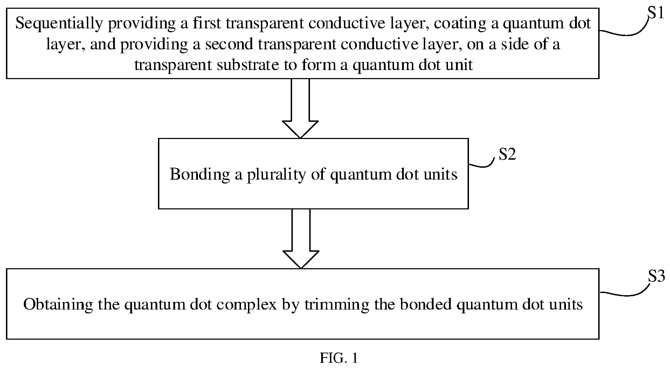

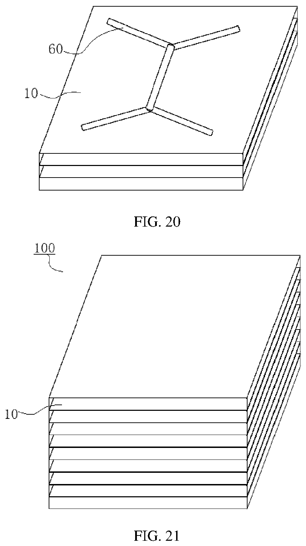

A process for a quantum dot complex according to the embodiments of the present disclosure is described with reference to FIG. 1 to FIG. 21.

As illustrated in FIG. 1, a process for a quantum dot complex according to embodiments of a first aspect of the present disclosure includes the following steps.

At S1, a quantum dot unit is formed by sequentially providing a first transparent conductive layer, coating a quantum dot layer, and providing a second transparent conductive layer, on a side of a transparent substrate. In an exemplary embodiment of the present disclosure, during preparation of the transparent substrate, an ultra-thin glass flat plate manufactured by such processes, like a floating method, an overflow stretching method, a slit stretching method, and a secondary stretching method, may be selected. Moreover, a thickness of a base material ranges from 0.1 mm to 5 mm. Surface type detection is performed on the glass flat plate, to ensured that an error of parallelism and planeness of each of an upper smooth surface and a lower smooth surface of the transparent substrate is smaller than or equal to ± 2 µm. A length a and a width b of a glass unit are preferably in a range of: 1 mm≤a≤500 mm, and 1 mm≤b≤500 mm. In addition, a resin transparent plate may also be selected as the base material.

Transparent glass is used as the transparent substrate. In an exemplary embodiment of the present disclosure, a transparent conductive layer may be made of an ITO material or other transparent conductive materials. When an ITO layer is used as the transparent conductive layer, a layer of a first ITO layer is plated on the transparent substrate. A layer of light-emitting quantum dots is spin-coated on the first ITO layer. Finally, a layer of a second ITO layer is plated on a light-emitting quantum dot layer. Most carriers of the first ITO layer and the second ITO layer are different, i.e., carriers in one of the first ITO layer and the second ITO layer are n-type ITO, and carriers in another one of the first ITO layer and the second ITO layer are a p-type ITO. In this way, an ITO-quantum dot-ITO PN junction structure is formed on a single transparent substrate 11. A refractive index of the ITO is similar to a refractive index of the transparent glass flat plate. Moreover, an error of the refractive index of the ITO and the refractive index of the transparent glass flat plate is smaller than or equal to 0.01. An ITO plating manner may be magnetron sputtering, vacuum reaction evaporation, chemical vapor deposition, sol-gel method, and pulsed laser deposition. The magnetron sputtering is preferably performed because the magnetron sputtering is fast in ITO plating speed, compact in film layer, and high in uniformity. One of surfaces of the transparent substrate 11 plated with ITO is spin-coated with a solution where quantum dots are dissolved. Moreover, the quantum dots may be oil-soluble or water-soluble. A thickness of the spin-coated quantum dot layer ranges from 0.05 µm to 10 µm. A spin-coating rotational speed is determined by the required thickness and solution viscosity. According to the method, quantum dots in three light-emitting colors are spin-coated on different substrates, respectively, which are a red-light emitting quantum dot, a green-light emitting quantum dot, and a blue-light emitting quantum dot, respectively.

At S2, a plurality of quantum dot units is bonded.

At S3, the quantum dot complex is obtained by trimming the bonded quantum dot units.

Trimming the bonded quantum dot units may include leveling, curing, trimming, polishing, and the like.

The processing process proposed in the present disclosure can significantly improve uniformity of a light-emitting surface in each layer of a bulk material for three-dimensional display, light-emitting contrast, material transparency, depth resolution, and increase a viewing angle of a three-dimensional image, and the like.

In some embodiments, the plurality of quantum dot units is bonded. The bonding method includes the following steps.

At S21, a spacer is provided on at least one side of each of the plurality of quantum dot units. The spacer is a transparent polymer material member, a resin member, an optical glass member, or an optical crystal member

In an exemplary embodiment of the present disclosure, the spacer may be in one of a circular truncated cone shape, a cylindrical shape, an elliptical cylindrical shape, a long cylindrical shape, a cuboid shape, a prismatic shape, a spherical shape, and an ellipsoidal shape.

At S22, the plurality of quantum dot units is laminated to form a lamination body. Adjacent ones of the plurality of quantum dot units are spaced apart from each other by the spacer to form a gap for accommodating an adhesive

At S23, two opposite side surfaces of the lamination body are sealed, and another two opposite side surfaces of the lamination body are used as an adhesive introducing surface and an adhesive discharging surface.

At S24, the adhesive is injected to introduce the adhesive from the adhesive introducing surface and fill the gap, to form a layer of cured adhesive containing the spacer between the adjacent quantum dot units.

In some embodiments, the spacer has a height ranging from 1 µm to 500 µm. A distance between adjacent spacers ranges from 0.1 mm to 5 mm. An error on the heights of a plurality of spacers is smaller than or equal to 2 µm. A distribution of the spacer is preferably a matrix distribution. The equal-thickness spacers are discretely formed in a regular array in advance. In this way, after the spacers are laminated, adjacent coating film units are raised by the spacers, so as to form equal-thickness gaps.

Therefore, parallelism of each quantum dot unit is ensured. Moreover, parallelism and flatness of the finally processed quantum dot complex are made better.

A method for arranging the spacer may be any one of the following:
1) A method for printing by spraying a transparent UV adhesive or silk-screen printing. The spacer is made of a material doped with a fast-curing resin. For example, after liquid drops are formed, rapid curing can be performed through UV light, to ensure that the spacers have a same height. The spacer may be in a shape of circle, square, line, or other patterns, preferably a circular dot pattern, from a top view, and the dot diameter ranges from 0.05 mm to 2 mm.
2) A photo-etching or an etching method. A photoresist is coated on a surface to be applied, and exposing, developing, etching, and removing the rest of the photoresist are performed on the surface to be applied. The photoresist is a positive adhesive or a negative adhesive. A photo-etching or etching method is used to manufacture the spacer, which means that the spacer is manufactured directly on the surface to be applied with processed like photoresist coating, exposure, development, etching, residual photoresist removal, and the like. The photoresist used can be a positive adhesive or a negative adhesive. The etching can be performed by wet etching or dry etching. Moreover, the photoresist needs to be spin-coated on a surface that does not need to be etched to perform protection when a photo-etching method is used to manufacture the spacer.
3) Nanoimprint and nanotransfer printing

In some embodiments, a distance between adjacent spacers ranges from 5 µm to 20 mm. The spacer is selectable from one of silicon dioxide microsphere, polystyrene microsphere, and polymethyl methacrylate microsphere. The spacer has a spherical diameter ranging from 1 µm to 200 µm. An error on consistency of the diameter is smaller than 10%.

Therefore, by using a size of the spacer, a spacer layer is infiltrated and wrapped with adhesive, and the spacer does not interfere with an optical path.

Further, before sealing or before the adhesive is cured, the method further includes: adjusting parallelism and planeness of the lamination body to control an error on each of the parallelism and the planeness within ± 5 µm. Therefore, processing precision of the lamination body is ensured.

In some embodiments, the lamination body is sealed by using a liquid sealant or a solid sealant. The liquid sealant is an epoxy resin or an acrylic resin, and the solid sealant is a rubber plate or a silicone adhesive. The liquid sealant has viscosity greater than 20000 cps, and is hardened through normal-temperature natural hardening, heating hardening, or ultraviolet irradiation hardening. The hardened liquid sealant has shore hardness ranging from 20 A to 70 A. Therefore, a sealing effect on the lamination body is better. Moreover, hardness and strength of a sealant region of the lamination body are ensured.

Further, the adhesive is defoamed before being injected. The adhesive has viscosity smaller than 500 cps. The adhesive is an epoxy resin or an acrylic resin. The cured adhesive has a volume shrinkage rate smaller than 1.1%, shore hardness ranging from 60 D to 80 D, and a refractive index same as a refractive index of the transparent substrate. In this way, by using the above adhesive, an adhesive effect is better.

In some embodiments, the adhesive is injected through one of a first gravity injection, a second gravity injection, a first pressure injection, a second pressure injection, and a vacuum injection. The first gravity injection includes: placing the adhesive introducing surface of the lamination body in an adhesive pool of a gravity adhesive feeding device; connecting sealingly the gravity adhesive feeding device and the adhesive introducing surface through a sealing material or a sealing tool; placing the lamination body and the adhesive feeding device into a vacuum chamber of a vacuum device; filling the gap with the adhesive through gravity of the adhesive and a capillary of the adhesive; closing the vacuum device in response to observing the adhesive uniformly seeps at all positions of the adhesive discharging surface; and completing the injection of the adhesive. The second gravity injection includes: placing the adhesive introducing surface of the lamination body in an adhesive pool of a gravity adhesive feeding device; connecting sealingly the gravity adhesive feeding device and the adhesive introducing surface through a sealing material or a sealing tool; connecting a vacuum device at the adhesive discharging surface to wrap the entire adhesive discharging surface of the lamination body; isolating the adhesive discharging surface from external environment through the sealing material or the sealing tool; setting an absolute vacuum degree of the vacuum device to be smaller than 10 kpa; closing the vacuum device in response to observing the adhesive uniformly seeps at all positions of the adhesive discharging surface; and completing the injection of the adhesive. The first pressure injection includes: placing the adhesive introducing surface of the lamination body in an adhesive of a pressure adhesive feeding device; connecting sealingly the pressure adhesive feeding device and the adhesive introducing surface through a sealing material or a sealing tool; applying a mechanical pressure to allow the gap to be full of the adhesive; monitoring an adjustment pressure by a pressure sensor mounted at the pressure adhesive feeding device to control an adhesive feeding speed; closing a pressure applying device in response to observing the adhesive uniformly seeps at all positions of the adhesive discharging surface; and completing the injection of the adhesive. The second pressure injection includes: placing the adhesive introducing surface of the lamination body in an adhesive of a pressure adhesive feeding device; connecting sealingly the pressure adhesive feeding device and the adhesive introducing surface through a sealing material or a sealing tool; applying an atmospheric pressure to allow the gap to be full of the adhesive; monitoring an adjustment air pressure by a gas flow valve mounted at the pressure adhesive feeding device to control an adhesive feeding speed; closing a pressure applying device in response to observing the adhesive uniformly seeps at all positions of the adhesive discharging surface; and completing the injection of the adhesive,. The vacuum injection includes: immersing the adhesive introducing surface of the lamination body in an adhesive pool containing the adhesive to liquid-seal the entire adhesive introducing surface by the adhesive; connecting a vacuum device at the adhesive discharging surface to wrap the entire adhesive discharging surface of the lamination body by the vacuum device; isolating the adhesive discharging surface from an external environment through a sealing material or a sealing tool; setting an absolute vacuum degree of the vacuum device smaller than 10 kpa; closing the vacuum device in response to observing the adhesive uniformly seeps at all positions of the adhesive discharging surface; and completing the injection of the adhesive.

Therefore, by injecting the adhesive in the above manners, adhesive efficiency is higher.

In some embodiments, the plurality of quantum dot units is bonded, and the bonding method includes the following steps.

At S25, after a first quantum dot unit is coated with the adhesive, a second quantum dot unit is placed on the adhesive 60 for bonding, and this process is repeated to form a laminated structure.

At S26, parallelism and flatness of the laminated structure prior to curing the laminated structure are adjusted.

In this way, there is no need to provide a spacer. By adopting a spin coating lamination manner, a spacing between adjacent quantum dot units is smaller. Therefore, the influence on the optical path is smaller.

In some embodiments, the adhesive preferably has viscosity smaller than 1000 cps. The adhesive is an epoxy resin or an acrylic resin. The cured adhesive has a volume shrinkage rate smaller than 1.1% and shore hardness ranging from 60D to 80D. Therefore, the above adhesive is determined in the above lamination and bonding manner, and the adhesive effect is better.

In an exemplary embodiment of the present disclosure, processing the plurality of quantum dot units includes the following steps.

At S11, a first photoresist layer is coated at a side of the transparent substrate.

At S12, exposing and developing are performed to retain a part of the first photoresist layer to form a first residue portion.

At S13, the first transparent conductive layer is plated at an exposure and development side of the transparent substrate.

At S14, the first residue portion is peeled to form a first protrusion on the first transparent conductive layer. The first protrusion is located at a side of a peeling region, and configured to be connected to a first electrode.

At S15, the quantum dot layer is coated at a side where the first transparent conductive layer is located.

At S16, a second photoresist layer is coated.

At S17, exposing and developing are performed to retain a part of the second photoresist layer to form a second residue portion. The second residue portion and the first residue portion are arranged close to an edge of the transparent substrate.

At S18, the second transparent conductive layer is plated at the exposure and development side of the transparent substrate.

At S19, the second residual portion is peeled to form a second protrusion on the second transparent conductive layer. The second protrusion is located at a side of the second residual portion, and configured to be connected to a second electrode. The first protrusion is offset from the second protrusion.

Therefore, a quantum body unit layer forms the transparent conductive layer in a manner of plating the first transparent conductive layer and the second transparent conductive layer, to realize independent application of an electric field of each quantum body unit layer. In this way, independent display of each quantum body unit layer can be realized.

A processing method for a three-dimensional display element according to embodiments of a second aspect of the present disclosure includes: the process for the quantum dot complex according to the above embodiments; providing a first electrode and a second electrode, in which the first electrode is electrically connected to a first transparent conductive layer of each quantum dot unit, and the second electrode is electrically connected to a second transparent conductive layer of each quantum dot unit; and attaching a circuit board to a side of the quantum dot complex, and connecting the circuit board to the first electrode and the second electrode.

In this way, the first electrode and the second electrode are connected to the circuit, allowing the quantum dots to have high photoluminescence quantum efficiency in a case where no electric field is added. After a predetermined electric field is applied, the photoluminescence quantum efficiency is lowered and even close to zero. In addition, photons absorbed by the quantum dots are almost emitted in a non-radiation relaxation manner. After the electric field is removed, light-emitting efficiency of the quantum dots can also be restored to the initial state.

A quantum dot complex 100 according to embodiments of a third aspect of the present disclosure includes: a plurality of quantum dot units 10 sequentially laminated and bonded to each other in a thickness direction. Each of the plurality of quantum dot units 10 includes a transparent substrate 11, a first transparent conductive layer, a second transparent conductive layer, a quantum dot layer 13. The first transparent conductive layer and the quantum dot layer 13 are located at a side of the transparent substrate 11 and sequentially arranged away from the transparent substrate 11. The second transparent conductive layer is located at another side of the transparent substrate 11 or located outside the quantum dot layer 13. One of the first transparent conductive layer 12 and the second transparent conductive layer 14 is a P-type semiconductor, and another one of the first transparent conductive layer 12 and the second transparent conductive layer 14 is an N-type semiconductor. The quantum dot layer 13, the first transparent conductive layer, and the second transparent conductive layer of a quantum dot unit 10 where the first transparent conductive layer 13 is located or of a quantum dot unit 10 adjacent to the quantum dot unit 10 where the first transparent conductive layer 13 is located are formed as a PN junction.

The present disclosure provides a novel quantum dot complex 100. In an exemplary embodiment of the present disclosure, a bulk structure having a multi-layer multicolor light-emitting quantum dot unit 10 is manufactured by using an effect of a reduction in the light-emitting efficiency of the photoluminescence quantum dots under modulation of the electric field through a technology of compounding the quantum dot, the transparent conductive material, and other transparent materials. Then, a three-dimensional pattern is scanned in the bulk structure by using a laser scanning system and an electric field modulation system.

In the case where no electric field is added, the quantum dots have higher photoluminescence quantum efficiency. After a predetermined electric field is applied, the photoluminescence quantum efficiency is lowered and even close to zero. Moreover, the photons absorbed by the quantum dots are almost emitted in the non-radiation relaxation mode. After the electric field is removed, the light-emitting efficiency of the quantum dots can also be restored to the initial state. This characteristic of the quantum dot is referred to as a switching effect of quantum dot electric field modulation. In a case where an excitation light parameter is kept unchanged, a ratio of a light-emitting intensity of the quantum dot without adding the electric field to a light-emitting intensity of the quantum dot with the electric field is a switching ratio. The switching ratio is preferably greater than 20.

In order to ensure that under the same condition, brightness of light-emitting points in front of a laser incident surface of the bulk material is the same as brightness of light-emitting points in back of the laser incident surface of the bulk material. In this way, an energy loss problem of a laser passing through the quantum dot unit 10 is counteracted. Therefore, thicknesses of the quantum dot units 10 of the laser incident surface of the bulk material are required to be gradually increased from front to back. In other words, a side surface of the quantum dot complex 100 is formed as a laser incident surface. In a lamination direction of the quantum dot units 10, the greater a distance from the laser incident surface, the greater a thickness of the quantum dot unit 10.

In some embodiments, the quantum dot layer 13 has a thickness ranging from 0.05 µm to 10 µm; and/or the transparent substrate 11 has a thickness ranging from 0.1 mm to 0.5 mm. An error of parallelism and planeness of each of an upper smooth surface and a lower smooth surface of the transparent substrate 11 is smaller than or equal to ± 2 µm. A length a and a width b of the transparent substrate 11 satisfy 1 mm≤a≤500 mm, and 1 mm≤b≤500 mm. Therefore, the quantum dot layer 13 uses the above size. Moreover, the manufactured quantum dot complex 100 is more compact in structure.

In another exemplary embodiment of the present disclosure, a quantum dot layer 13 of each quantum dot unit 10 is configured to emit light in one color when being irradiated. A structure of a quantum dot complex 100 monochromatically displayed is that light-emitting layer units of single-color emission quantum dots are periodically arranged. Moreover, the layer units and the layer units are bonded to each other by a transparent adhesive. Electrodes are manufactured on both surfaces of each layer of quantum dot layer 13 and have the function of applying an electric field with an adjustable size and direction to the quantum dots.

In another exemplary embodiment of the present disclosure, every three adjacent quantum dot units 10 are defined as a color adjustment group. Quantum dot layers 13 of three quantum dot units 10 in each color adjustment group are configured to respectively emit red light, green light, and blue light when being irradiated. For example, an arrangement rule of the unit layer is: a red-light emitting quantum dot unit 10, a green-light emitting quantum dot unit 10, and a blue-light emitting quantum dot unit 10. The quantum dot units 10 in three colors are periodically arranged. The unit layer and the unit layer are bonded to each other through the transparent adhesive. The two surfaces of each quantum dot unit 10 are manufactured with transparent electrodes, which have the function of applying the electric field with the adjustable size and direction to the quantum dots.

A three-dimensional display element according to embodiments of a fourth aspect of the present disclosure includes: the quantum dot complex 100 according to the above embodiments and a circuit board. The circuit board is electrically connected to a first transparent conductive layer 12 and a second transparent conductive layer 14 of each quantum dot unit 10 by a first electrode and a second electrode, respectively.

Compared with three-dimensional display of liquid crystal lamination, a three-dimensional display element modulated by the electric field and a light field has the following advantages.

First, an image frame rate is higher. A modulation time of quantum dot screen modulated by a single-layer electric field is smaller than 10 µs, while a single refresh time of the liquid crystal layer is an ms level.

Second, three-dimensional imaging longitudinal resolution is higher. Resolution of the liquid crystal layer in a three-dimensional display depth direction is limited since a refresh speed of the liquid crystal layer is slow. For example, when the refresh speed of the liquid crystal layer is 1 ms, it is calculated that according to a human eye visual persistence effect being 25 Hz, a maximum lamination number of the liquid crystal layer is 40 layers. Frame frequency must be sacrificed if more layers want to be laminated. A modulation time of the quantum dot screen modulated by the single-layer electric field is smaller than 10 µs. Moreover, it is calculated that 4000 layers can be laminated with 10 µs and 25 Hz

Third, a viewing angle is greater. Due to the limitation of a frame of the liquid crystal screen, a viewing angle of the three-dimensional display of the liquid crystal layer is limited to a small angle on a front surface, and a side surface and a back surface of the liquid crystal layer cannot be viewed. In addition, the image cannot be viewed in a small region of a surface of an electrode arrangement of a three-dimensional display system based on dual modulation of the light field and the electric field. Except for this, viewing can be performed in the rest of directions.

Fourth, a color gamut is higher. A light source used by a three-dimensional display system of the liquid crystal lamination is LED backlight. However, the three-dimensional display system based on the dual modulation of the light field and the electric field adopts photoluminescence quantum dots. It is well known that the quantum dots have a higher color gamut than the LED

A manufacturing process flow of the quantum dot complex 100 in two specific embodiments is briefly described below.

First Embodiment: A siphon method is used for manufacturing the quantum dot complex 100.

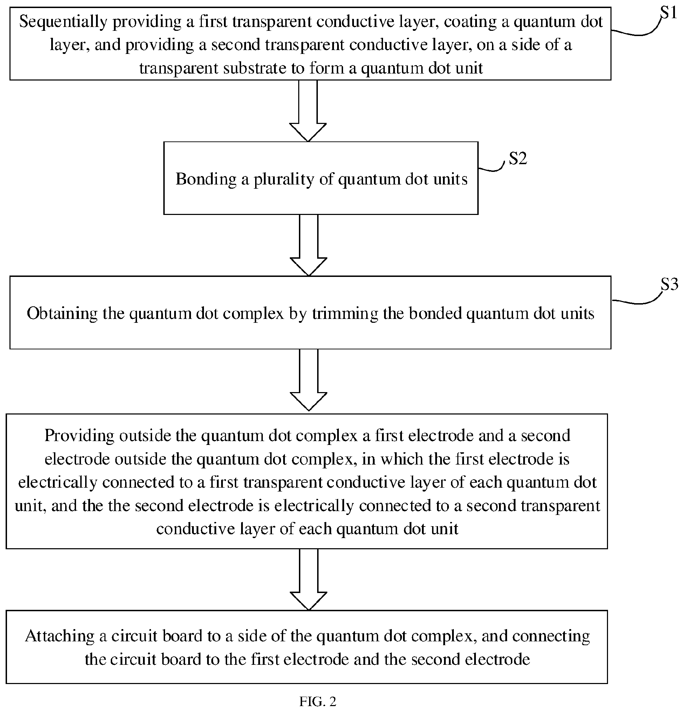

FIG. 2 is a process flow of manufacturing a quantum dot complex 100 according to an embodiment.

### 1) Preparation of the transparent substrate 11

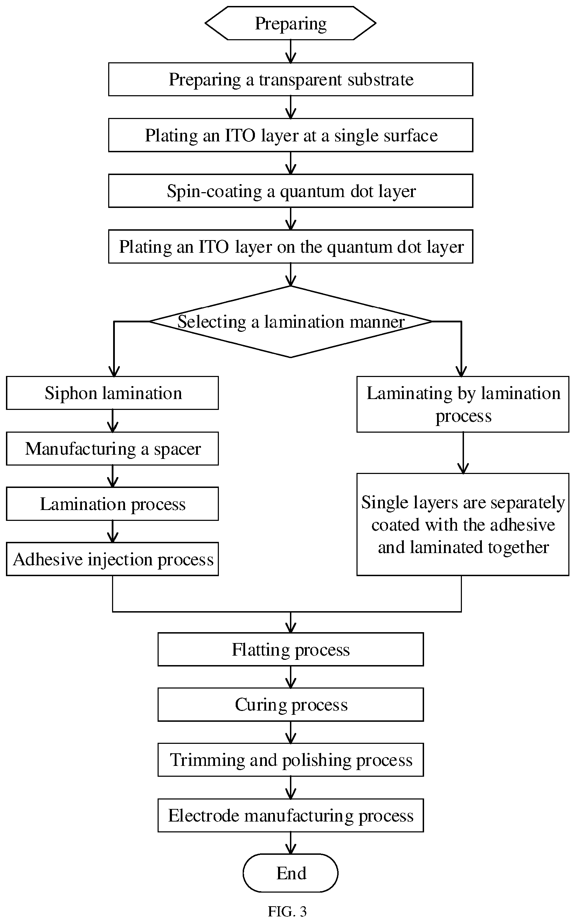

FIG. 3 is an ultra-thin glass flat plate manufactured by a transparent base material selecting a process such as a float method, an overflow stretching method, a slit stretching method, and a secondary stretching method. A thickness of a base material ranges from 0.1 mm to 5 mm. Surface type detection is performed on the glass flat plate, to ensured that an error of parallelism and planeness of each of an upper smooth surface and a lower smooth surface of the transparent substrate is smaller than or equal to ± 2 µm. A length a and a width b of a glass unit are preferably in a range of: 1 mm≤a≤500 mm, and 1 mm≤b≤500 mm. In addition, a resin transparent plate may also be selected as the base material.

### 2) Quantum dot application process

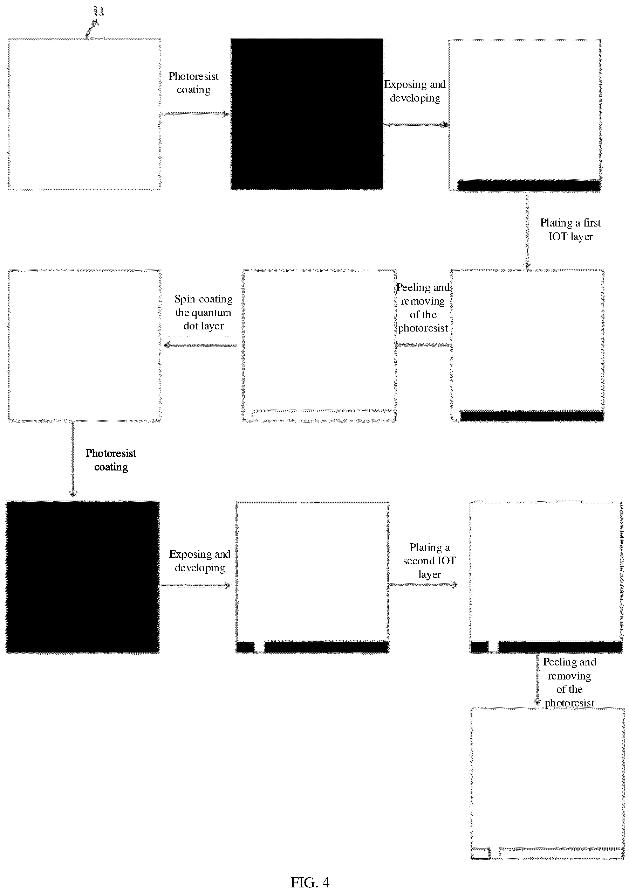

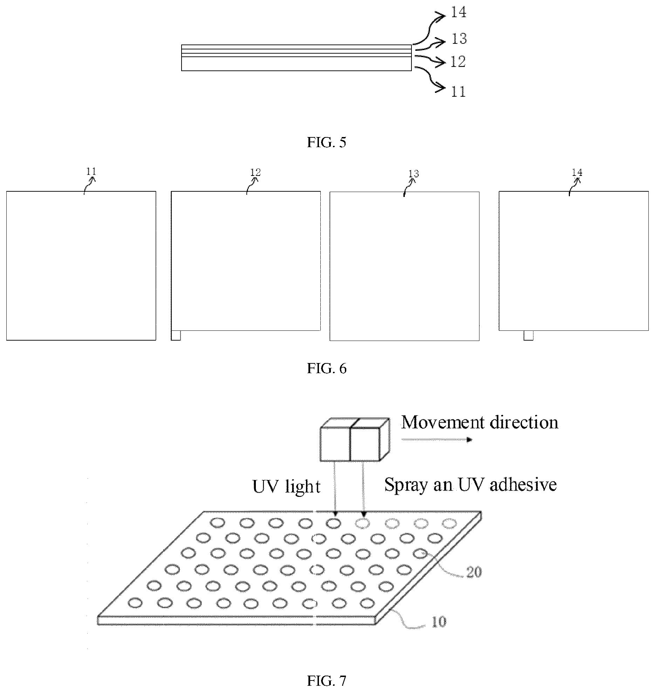

FIG. 4 shows a structure processing process of a single-layer quantum dot unit 10. FIG. 5 shows a shape feature of a structure in each layer. The transparent substrate 11 is transparent glass. A layer of a first ITO layer 12 is plated on the transparent substrate 11. A layer of light-emitting quantum dots 13 is spin-coated on the first ITO layer 12. Finally, a layer of a second ITO layer 14 is plated on the quantum dot layer 13 again. Most carriers of the first ITO layer and the second ITO layer are different, i.e., carriers in one of the first ITO layer and the second ITO layer are n-type ITO, and carriers in another one of the first ITO layer and the second ITO layer are a p-type ITO. In this way, an ITO-quantum dot-ITO PN junction structure is formed on a single transparent substrate 11. A refractive index of the ITO is similar to a refractive index of the transparent glass flat plate. Moreover, an error of the refractive index of the ITO and the refractive index of the transparent glass flat plate is smaller than or equal to 0.01. An ITO plating manner may be magnetron sputtering, vacuum reaction evaporation, chemical vapor deposition, sol-gel method, and pulsed laser deposition. The magnetron sputtering is preferably performed because the magnetron sputtering is fast in ITO plating speed, compact in film layer, and high in uniformity. One of surfaces of the transparent substrate 11 plated with ITO is spin-coated with a solution where quantum dots are dissolved. Moreover, the quantum dots may be oil-soluble or water-soluble. A thickness of the spin-coated quantum dot layer 10 ranges from 0.05 µm to 10 µm. A spin-coating rotational speed is determined by the required thickness and solution viscosity. According to the method, quantum dots in three light-emitting colors are spin-coated on different substrates, respectively, which are a red-light emitting quantum dot, a green-light emitting quantum dot, and a blue-light emitting quantum dot, respectively.

In addition, N-type ITO may also select other N-type transparent semiconductor materials, and P-type ITO may also select other P-type transparent semiconductor materials.

In order to ensure that under the same condition, brightness of light-emitting points in front of a laser incident surface of the bulk material is the same as brightness of light-emitting points in back of the laser incident surface of the bulk material. In this way, an energy loss problem of a laser passing through the quantum dot unit 10 is counteracted. Therefore, thicknesses of the quantum dot layers 13 of the laser incident surface of the bulk material are required to be gradually increased from front to back.

### 3) Manufacture of the spacers 20

A forming step of the spacer 20 is that the equal-thickness spacers 20 are discretely formed in a regular array in advance. In this way, after the spacers are laminated, adjacent coating film units are raised by the spacers 20, so as to form equal-thickness gaps.

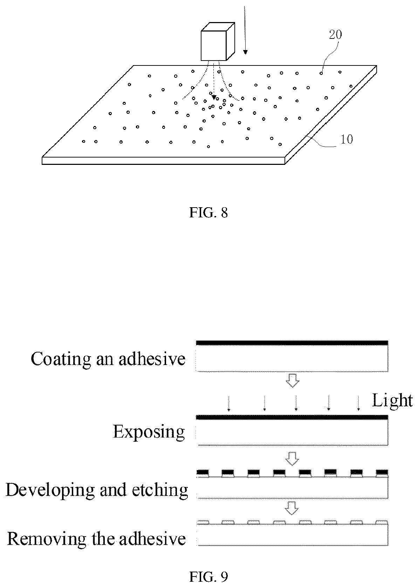

The spacer 20 may be formed by printing by spraying the transparent UV adhesive (FIG. 7), silk-screen printing, a photolithography-etching method (FIG. 8), nanoimprint, and nanotransfer printing, and the like. The spacer has a height ranging from 1 µm to 500 µm. A distance between adjacent spacers ranges from 0.1 mm to 5 mm. An error on the heights of a plurality of spacers is smaller than or equal to 2 µm. A distribution of the spacer 20 is preferably a matrix distribution.

When the spacer 20 is manufactured through printing by spraying the transparent UV adhesive (FIG. 7) or silk-screen printing, the spacer 20 is made of a material doped with a fast-curing resin. For example, after liquid drops are formed, rapid curing can be performed through UV light, to ensure that the spacers 20 have a same height. The spacer 20 may be in a shape of circle, square, line, or other patterns, preferably a circular dot pattern, from a top view, and the dot diameter ranges from 0.05 mm to 2 mm.

The spacer 20 is fabricated by the photo-etching method or the etching method (FIG. 8), which means that the spacer 20 is manufactured directly on the surface to be applied with photoresist coating, exposure, development, etching, residual photoresist removal, and the like. The photoresist used can be a positive adhesive or a negative adhesive. The etching can be performed by wet etching or dry etching. Moreover, the photoresist needs to be spin-coated on a surface that does not need to be etched to perform protection when a photo-etching method is used to manufacture the spacer 20.

In addition, other granular materials with uniform sizes may also be used as spacers 20, and are uniformly dispersed between two layers of substrate units spin-coated with the light-emitting quantum dots. A distance between two adjacent particles is D, where D satisfies 5 µm≤D≤20 mm. A contour dimension of the spacer 20 may satisfy in any one of a circular truncated cone shape, a cylindrical shape, an elliptical cylindrical shape, a long cylindrical shape, a cuboid shape, a prismatic shape, a spherical shape, and an ellipsoidal shape. A spherical shape, a diameter ranging from 1 µm to 200 µm, and an error on consistency of the diameter smaller than 10% are preferred. An application manner of the spacer 20 is a method for spraying a microsphere spacer (FIG. 9). The microsphere spacer 20 may be silicon dioxide microsphere, polystyrene microsphere, and polymethyl methacrylate microsphere. In addition, the granular spacer 20 may also be a polymer material member, a resin member, an optical glass member or an optical crystal member.

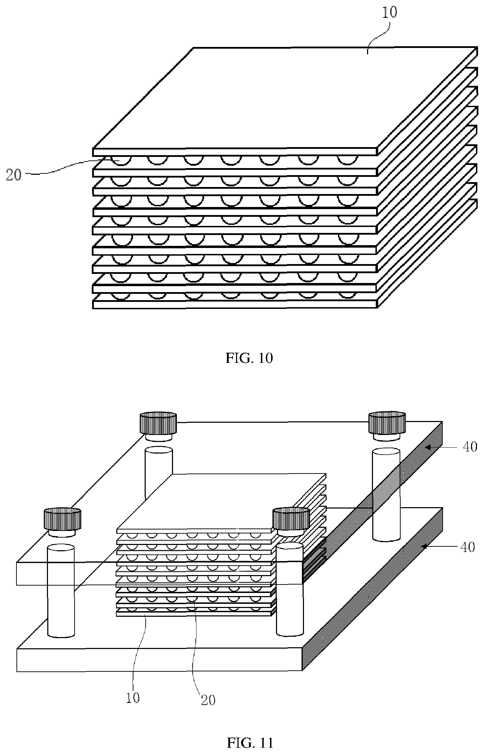

4) As illustrated in FIG. 10, lamination is performed on the transparent substrate 11 that makes the spacer 20.

For full-color imaging, a lamination rule is that: ∘,1 quantum dot units 10 in each layer have the same direction; and ∘,2 an arrangement rule of periodically arranging the quantum dot light-emitting layer units in three colors including the red-light emitting quantum dot unit 10, the green-light emitting quantum dot unit 10, and the blue-light emitting quantum dot unit 10.

For monochromatic imaging, a lamination rule is ∘,1 using a quantum dot light-emitting layer in a color to laminate; and ∘,2 that quantum dot units 10 in each layer have the same direction.

5) Parallelism and planeness of the lamination body are adjusted. As illustrated in FIG. 11, the laminated lamination body is clamped by the rigid plate body 40 or a gasbag. Moreover, parallelism and planeness of each of a unit at an uppermost layer and a unit at a lowermost layer are adjusted through a parallelism adjustment device. In this way, by assuming that an error on each of the parallelism and the planeness is controlled within ±5 µm, the accumulated error of the parallelism and flatness caused by unequal thickness of each of the spacer 20, the transparent substrate 11, and the spin-coated quantum dot layer 13 in each layer of unit are corrected. The process may also be performed after the adhesive is injected and before the adhesive 60 is cured.

### 6) Sealing process

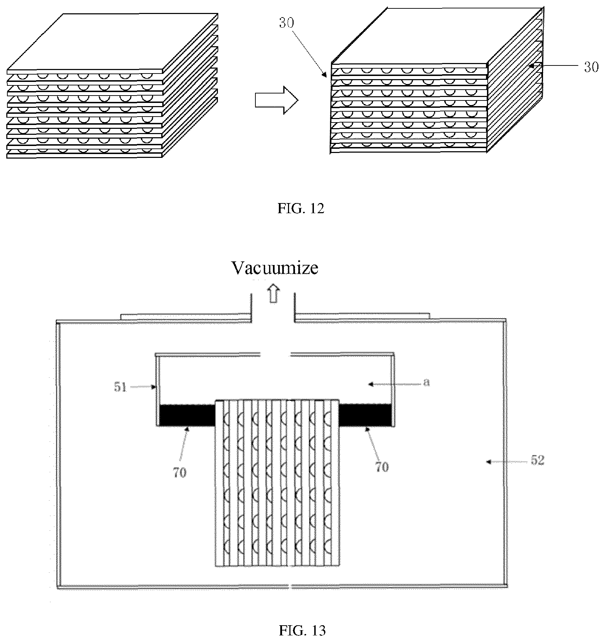

Two opposite surfaces among four surfaces of the lamination body perpendicular to a lamination direction are selected as sealing surfaces, and a sealant 30 is used to seal the sealing surface. As illustrated in FIG. 12, the sealant 30 is a solid sealing material or a liquid sealing material. When the liquid sealant 30 is the liquid sealing material and has viscosity greater than 20000 cps, the liquid sealant 30 is made of an epoxy resin or an acrylic resin, and is hardened through normal-temperature natural hardening, heating hardening, or ultraviolet irradiation hardening. The hardened liquid sealant has shore hardness ranging from 20 A to 70 A. When the liquid sealant 30 is the solid sealing material, a rubber plate or a silicone adhesive with good ductility can be selected. A sealing effect can also be achieved by tightly pressing and attaching the sealing surface through a sealing tool.

### 7) Adhesive injection process

One of another two opposite surfaces among four surfaces of the lamination body parallel to the lamination direction is selected as the adhesive introducing surface, and another one of the other two opposite surfaces is used as the adhesive discharging surface. A curing adhesive 60 enters a spacer layer in a middle of the substrate unit from the adhesive introducing surface and is led out from the adhesive discharging surface. In this way, each spacer layer is filled with the adhesive 60 uniformly to complete injection. The injected adhesive 60 has viscosity smaller than 500 cps preferably and is cured through heating curing or normal-temperature natural curing. The adhesive 60 is an epoxy resin or an acrylic resin. The cured adhesive 60 preferably has a volume shrinkage rate smaller than 1.1% and shore hardness ranging from 60 D to 80 D. The adhesive 60 is defoamed before being injected. The color of the adhesive 60 is preferably transparent. An error between a refractive index of the cured adhesive 60 and a refractive index of the transparent substrate 11 is smaller than 0.01.

The adhesive injection method includes gravity injection, pressure injection, and vacuum injection.

A first gravity injection 1 is provided. The adhesive introducing surface of the lamination body is placed in a gravity adhesive feeding device, i.e., an adhesive. As illustrated in FIG. 13, a sealing connection between the gravity adhesive feeding device and the adhesive introducing surface is carried out through a sealing material or a sealing tool. The lamination body and the adhesive feeding device are placed into a vacuum chamber 52 of a vacuum device. A gap layer is filled with bonding glue a through gravity of the adhesive and a capillary of the adhesive. The vacuum device may be closed in response to observing the adhesive 60 uniformly seeps at all positions of the adhesive discharging surface, and completing the injection of the adhesive 60.

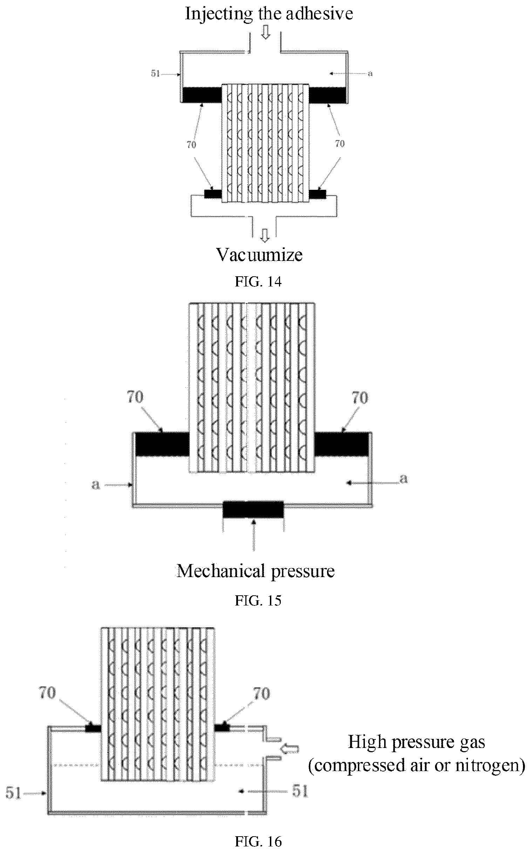

A second gravity injection 2 includes placing the adhesive introducing surface of the lamination body in an adhesive pool of a gravity adhesive feeding device. As illustrated in FIG. 14, a sealing connection between the gravity adhesive feeding device and the adhesive introducing surface is carried out through a sealing material or a sealing tool. Then, a vacuum device is connected at the adhesive discharging surface to wrap the entire adhesive discharging surface of the lamination body. Moreover, the adhesive discharging surface is isolated from an external environment through the sealing material or the sealing tool, to ensure that no air leakage phenomenon occurs during vacuumizing. An absolute vacuum degree of the vacuum device is set to be smaller than 10 kpa preferably. The vacuum device may be closed in response to observing the adhesive 60 uniformly seeps at all positions of the adhesive discharging surface, and completing adhesive 60 injection.

A first pressure injection 1 includes placing the adhesive introducing surface of the lamination body in an adhesive of a pressure adhesive feeding device. As illustrated in FIG. 15, a sealing connection between the pressure adhesive feeding device and the adhesive introducing surface is carried out through a sealing material or a sealing tool. A mechanical pressure is applied to allow the gap to be full of the adhesive. An adjustment pressure is monitored by a pressure sensor mounted at the pressure adhesive feeding device to control an adhesive feeding speed. A pressure applying device may be closed in response to observing the adhesive 60 uniformly seeps at all positions of the adhesive discharging surface, and completing adhesive 60 injection.

As illustrated in FIG. 16, a second pressure injection 2 includes: placing the adhesive introducing surface of the lamination body in an adhesive of a pressure adhesive feeding device, connecting sealingly the pressure adhesive feeding device and the adhesive introducing surface through a sealing material or a sealing tool, applying an atmospheric pressure to allow the gap to be full of the adhesive, and monitoring an adjustment air pressure by a gas flow valve mounted at the pressure adhesive feeding device to control an adhesive feeding speed. In addition, a pressure applying device may be closed in response to observing the adhesive 60 uniformly seeps at all positions of the adhesive discharging surface, and completing adhesive 60 injection.

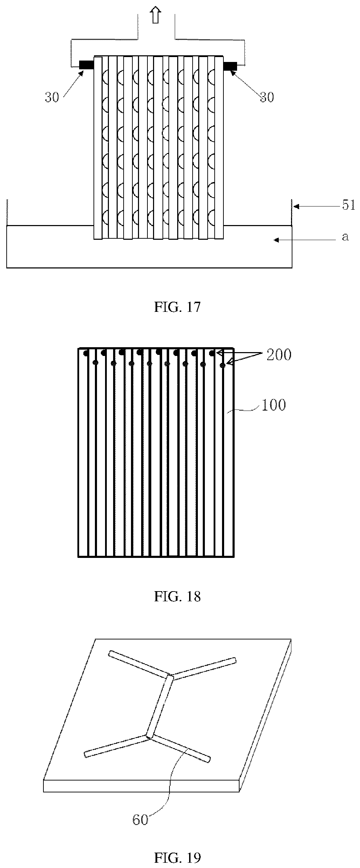

As illustrated in FIG. 17, a vacuum injection includes: immersing the adhesive introducing surface of the lamination body in an adhesive pool 51 containing the adhesive 60 to liquid-seal the entire adhesive introducing surface by the adhesive 60. Then, a vacuum device is connected at the adhesive discharging surface to wrap the entire adhesive discharging surface of the lamination body by the vacuum device. Moreover, the adhesive discharging surface is isolated from an external environment through a sealing material or a sealing tool, to ensure that no air leakage phenomenon occurs during vacuumizing. An absolute vacuum degree of the vacuum device is set to be smaller than 10 kpa. The vacuum device may be closed in response to observing the adhesive 60 uniformly seeps at all positions of the adhesive discharging surface, and completing adhesive 60 injection.

### 8) Curing and heat treatment processes

After the injection of the adhesive 60 is completed, the adhesive 60 can be cured by heating for a period of time or through constant-temperature placement for a period of time. Moreover, internal stress is eliminated in a necessary heat treatment manner to obtain a lamination block. Before curing, parallelism and planeness of each of a coating film unit at an uppermost layer of the lamination block and a coating film unit at a lowermost of the lamination block can be corrected through the parallelism adjustment device. For example, the lamination block can be laminated and engaged by using a precision hydraulic device, with a pressing force greater than or equal to 20 kPa. The lamination block is corrected through the parallelism and planeness of an operation surface of a press machine. Moreover, the correction of the lamination block is continuously kept until the adhesive 60 is cured.

9) A trimming and polishing process. Trimming and polishing processes are performed on the cured lamination block sequentially. A trimming purpose is processing the lamination block into an approximately standard cube, and then polishing each surface of the lamination block, allowing the lamination body to maintain high light transmittance and prepare for the next process.

10) The manufacture of the electrode 20. The electrode 20 is manufactured by selecting one of the four surfaces of the lamination body perpendicular to the lamination direction to be photolithographed and coated. The electrode 20 is introduced into each layer of ITO. As illustrated in FIG. 18, it is ensured that no short circuit exists between the ITO layer and the layer. The electrode 20 may be made of gold or silver, preferably the gold.

11) An attaching printed circuit board and a welding wire. The circuit board manufactured as specifications is attached to a surface of the manufactured electrode 20. Moreover, the electrode 20 on the laminated body is connected to the attaching printed circuit board by using an ultrasonic wire welding machine. In order to achieve a greater viewing angle, it is preferable to make the electrode 20 on one surface. A voltage is applied to the ITO layer at both sides of the quantum dot layer 13 through a control system. The light-emitting efficiency of the quantum dots in the electric field decreases to near zero under the action of the electric field. Moreover, the full-color three-dimensional display can be achieved by controlling a magnitude of the applied electric field and the quantum dots in three colors including red, green, and blue.

### Second Embodiment: The lamination material is manufactured by the lamination method.

Lamination processes are performed on the unit layer that completes the process of FIG. 5.

The lamination process is as follows. As illustrated in FIG. 19, FIG. 20, and FIG. 21, a flat plate for completing the process of FIG. 5 is taken and placed on a flat plate tool. An upward surface of the flat plate is coated with an " 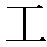 "-shaped adhesive 60. Then, a flat plate for completing the process of FIG. 5 is taken and placed on the adhesive 60, and has a same direction as the quantum dot unit 10 on the first flat plate, i.e., the quantum dot units 10 are both upwards or downwards. The adhesive 60 preferably has viscosity smaller than 1000 cps, and is cured through heating curing or normal-temperature natural curing. The adhesive 60 is an epoxy resin or an acrylic resin. Preferably, the cured adhesive 60 has a volume shrinkage rate smaller than 1.1%, shore hardness ranging from 60 D to 80 D. The adhesive 60 is defoamed before being injected. The color of the adhesive 60 is preferably transparent. A refractive index of the cured adhesive 60 is similar to a refractive index of the transparent substrate 11. An error between the refractive index of the cured adhesive 60 and the refractive index of the transparent substrate 11 is smaller than 0.01.

For full-color imaging, a lamination rule is that: ∘,1 quantum dot units 10 in each layer have the same direction; and ∘,2 an arrangement rule of periodically arranging the quantum dot light-emitting layer units 10 in three colors including the red-light emitting quantum dot unit 10, the green-light emitting quantum dot unit 10, and the blue-light emitting quantum dot unit 10.

For monochromatic imaging, a lamination rule is ∘,1 using a quantum dot light-emitting layer in a color to laminate; and ∘,2 that quantum dot units 10 in each layer have the same direction.

5) Parallelism and planeness of the lamination body are adjusted. Parallelism and planeness of each of a unit at an uppermost layer and a unit at a lowermost layer are adjusted through a parallelism adjustment device. In this way, by assuming that an error on each of the parallelism and the planeness is controlled within ±5 µm, the accumulated error of the parallelism and flatness caused by unequal thickness of each of the spacer 20, the transparent substrate 11, and the spin-coated quantum dot layer 13 in each layer of unit are corrected. The process may also be performed after the adhesive is injected and before the adhesive 60 is cured.

### 6) Curing and heat treatment processes

After the injection of the adhesive 60 is completed, the adhesive 60 can be cured by heating for a period of time or through constant-temperature placement for a period of time. Moreover, internal stress is eliminated in a necessary heat treatment manner to obtain a lamination block.

7) A trimming and polishing process. Trimming and polishing processes are performed on the cured lamination block sequentially. A trimming purpose is processing the lamination block into an approximately standard cube, and then polishing each surface of the lamination block, allowing the lamination body to maintain high light transmittance and prepare for the next process.

8) The manufacture of the electrode 20. The electrode 20 is manufactured by selecting one of the four surfaces of the lamination body perpendicular to the lamination direction to be photolithographed and coated. The electrode 20 is introduced into each layer of ITO. Moreover, it is ensured that no short circuit exists between the ITO layer and the layer. The electrode 20 may be made of gold or silver, preferably the gold.

9) An attaching printed circuit board and a welding wire. The circuit board manufactured as specifications is attached to a surface of the manufactured electrode 20. Moreover, the electrode 20 on the laminated body is connected to the attaching printed circuit board by using an ultrasonic wire welding machine. In order to achieve a greater viewing angle, it is preferable to make the electrode 20 at an edge close to the bulk material.

In the description of the present disclosure, it should be understood that, the orientation or the position indicated by technical terms such as "center", "longitudinal", "lateral", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation and the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation on the present disclosure.

In the description of the present disclosure, "the first feature" and "the second feature" may include at least one of the features. In the description of the present disclosure, "plurality" means at least two. In the description of the present disclosure, the first feature being "on" or "under" the second feature may include the scenarios that the first feature is in direct contact with the second feature, or the first and second features, instead of being in direct contact with each other, are in contact with each other through another feature therebetween. In the description of the present disclosure, the first feature being "above" the second feature may indicate that the first feature is directly above or obliquely above the second feature, or simply indicate that the level of the first feature is higher than that of the second feature.

In the description of this specification, descriptions with reference to the terms "an embodiment," "some embodiments," "schematic embodiments," "examples," "specific examples," or "some examples," etc. mean that specific features, structure, materials or characteristics described in conjunction with the embodiment or example are included in at least one embodiment or example of the present disclosure. In this specification, the schematic representations of the above terms do not necessarily refer to the same embodiment or example.

The scope of the present invention is defined by the appended claims.

## Claims

1. A processing method for a three-dimensional display element, the processing method comprising:
sequentially providing (S1) a first transparent conductive layer (12), coating a quantum dot layer (13), and providing a second transparent conductive layer (14), on a side of a transparent substrate (11) to form a quantum dot unit (10),
wherein processing the quantum dot unit (10) comprises:
coating a first photoresist layer at a side of the transparent substrate (11);
exposing and developing to retain a part of the first photoresist layer to form a first residue portion;
plating the first transparent conductive layer (12) at an exposure and development side of the transparent substrate (11);
peeling the first residue portion to form a first protrusion on the first transparent conductive layer (12), wherein the first protrusion is located at a side of a peeling region, and is configured to be connected to a first electrode;
coating the quantum dot layer (13) at a side where the first transparent conductive layer (12) is located;
coating a second photoresist layer;
exposing and developing to retain a part of the second photoresist layer to form a second residue portion, wherein the second residue portion and the first residue portion are arranged close to an edge of the transparent substrate (11);
plating the second transparent conductive layer (14) at the exposure and development side of the transparent substrate (11);
peeling the second residual portion to form a second protrusion on the second transparent conductive layer (14), wherein the second protrusion is located at a side of the second residual portion, and is configured to be connected to a second electrode, and wherein the first protrusion is offset from the second protrusion;
sequentially laminating and bonding (S2) a plurality of quantum dot units (10) in a thickness direction;
obtaining (S3) a quantum dot complex (100) by trimming the bonded quantum dot units (10);
providing the first electrode and the second electrode outside the quantum dot complex (100), wherein the first electrode is electrically connected to the first transparent conductive layer (12) of each quantum dot unit (10) of the plurality of quantum dot units (10), and wherein the second electrode is electrically connected to the second transparent conductive layer (14) of each quantum dot unit (10) of the plurality of quantum dot units (10); and
attaching a circuit board to a side of the quantum dot complex (100), and electrically connecting the circuit board to the first transparent conductive layer (12) and the second transparent conductive layer (14) of each quantum dot unit (10) of the plurality of quantum dot units (10) by the first electrode and the second electrode.

2. The processing method according to claim 1, wherein said sequentially laminating and bonding (S2) the plurality of quantum dot units (10) in a thickness direction comprises:
providing a spacer (20) on at least one side of each of the plurality of quantum dot units (10), wherein the spacer (20) is a transparent polymer material member, a resin member, an optical glass member, or an optical crystal member;
laminating the plurality of quantum dot units (10) to form a lamination body, wherein adjacent ones of the plurality of quantum dot units (10) are spaced apart from each other by the spacer (20) to form a gap for accommodating an adhesive (60);
sealing two opposite side surfaces of the lamination body, and using another two opposite side surfaces of the lamination body as an adhesive introducing surface and an adhesive discharging surface; and
injecting the adhesive (60) to introduce the adhesive (60) from the adhesive introducing surface and fill the gap, to form a layer of cured adhesive containing the spacer (20) between the adjacent quantum dot units (10).

3. The processing method according to claim 2, wherein the spacer (20) has a height ranging from 1 µm to 500 µm;
a distance between adjacent spacers (20) ranges from 0.1 mm to 5 mm; and
an error on the heights of a plurality of spacers (20) is smaller than or equal to 2 µm.

4. The processing method according to claim 2 or 3, wherein a distance between adjacent spacers (20) ranges from 5 µm to 20 mm;
the spacer (20) is selectable from one of silicon dioxide microsphere, polystyrene microsphere, and polymethyl methacrylate microsphere; and
the spacer (20) has a spherical diameter ranging from 1 µm to 200 µm, an error on consistency of the diameter being smaller than 10%.

5. The processing method according to any one of claims 2 to 4, further comprising, prior to sealing the two opposite side surfaces of the lamination body or curing the adhesive (60):
adjusting parallelism and planeness of the lamination body to control an error on each of the parallelism and the planeness within ± 5 µm.

6. The processing method according to any one of claims 2 to 5, wherein the lamination body is sealed by using a liquid sealant or a solid sealant, the liquid sealant being an epoxy resin or an acrylic resin, and the solid sealant being a rubber plate or a silicone adhesive,
wherein the liquid sealant has viscosity greater than 20000 cps, and is hardened through normal-temperature natural hardening, heating hardening, or ultraviolet irradiation hardening; and
wherein the hardened liquid sealant has shore hardness ranging from 20 A to 70 A.

7. The processing method according to any one of claims 2 to 6, wherein the adhesive (60) is defoamed before being injected;
the adhesive (60) has viscosity smaller than 500 cps;
the adhesive (60) an epoxy resin or an acrylic resin; and
the cured adhesive has a volume shrinkage rate smaller than 1.1%, shore hardness ranging from 60 D to 80 D, and a refractive index same as a refractive index of the transparent substrate (11).

8. The processing method according to any one of claims 2 to 7, wherein the adhesive (60) is injected through one of a first gravity injection, a second gravity injection, a first pressure injection, a second pressure injection, and a vacuum injection,
wherein the first gravity injection comprises:
placing the adhesive introducing surface of the lamination body in an adhesive pool (51) of a gravity adhesive feeding device;
connecting sealingly the gravity adhesive feeding device and the adhesive introducing surface through a sealing material or a sealing tool;
placing the lamination body and the adhesive feeding device into a vacuum chamber (52) of a vacuum device;
filling the gap with the adhesive (60) through gravity of the adhesive (60) and a capillary of the adhesive (60);
closing the vacuum device in response to observing the adhesive (60) uniformly seeps at all positions of the adhesive discharging surface; and
completing the injection of the adhesive (60);
wherein the second gravity injection comprises:
placing the adhesive introducing surface of the lamination body in an adhesive pool (51) of a gravity adhesive feeding device;
connecting sealingly the gravity adhesive feeding device and the adhesive introducing surface through a sealing material or a sealing tool;
connecting a vacuum device at the adhesive discharging surface to wrap the entire adhesive discharging surface of the lamination body;
isolating the adhesive discharging surface from an external environment through the sealing material or the sealing tool;
setting an absolute vacuum degree of the vacuum device to be smaller than 10 kpa;
closing the vacuum device in response to observing the adhesive (60) uniformly seeps at all positions of the adhesive discharging surface; and
completing the injection of the adhesive (60);
wherein the first pressure injection comprises:
placing the adhesive introducing surface of the lamination body in an adhesive of a pressure adhesive feeding device;
connecting sealingly the pressure adhesive feeding device and the adhesive introducing surface through a sealing material or a sealing tool;
applying a mechanical pressure to the adhesive (60) to allow the gap to be full of the adhesive (60);
monitoring an adjustment pressure by a pressure sensor mounted at the pressure adhesive feeding device to control an adhesive feeding speed;
closing a pressure applying device in response to observing the adhesive (60) uniformly seeps at all positions of the adhesive discharging surface; and
completing the injection of the adhesive (60);
wherein the second pressure injection comprises:
placing the adhesive introducing surface of the lamination body in an adhesive of a pressure adhesive feeding device;
connecting sealingly the pressure adhesive feeding device and the adhesive introducing surface through a sealing material or a sealing tool;
applying an atmospheric pressure to allow the gap to be full of the adhesive (60);
monitoring an adjustment air pressure by a gas flow valve mounted at the pressure adhesive feeding device to control an adhesive feeding speed;
closing a pressure applying device in response to observing the adhesive uniformly seeps at all positions of the adhesive discharging surface; and
completing the injection of the adhesive (60); and
wherein the vacuum injection comprises:
immersing the adhesive introducing surface of the lamination body in an adhesive pool (51) containing the adhesive (60) to liquid-seal the entire adhesive introducing surface by the adhesive (60);
connecting a vacuum device at the adhesive discharging surface to wrap the entire adhesive discharging surface of the lamination body by the vacuum device;
isolating the adhesive discharging surface from an external environment through a sealing material or a sealing tool;
setting an absolute vacuum degree of the vacuum device to be smaller than 10 kpa;
closing the vacuum device in response to observing the adhesive (60) uniformly seeps at all positions of the adhesive discharging surface; and
completing the injection of the adhesive (60).

9. The processing method according to any one of claims 1 to 8, wherein said sequentially laminating and bonding (S2) the plurality of quantum dot units (10) in a thickness direction comprises:
placing, subsequent to a first one of the plurality of quantum dot units (10) being coated with the adhesive (60), a second one of the plurality of quantum dot units (10) on the adhesive (60) for bonding, repeating this process to form a laminated structure; and
adjusting parallelism and flatness of the laminated structure prior to curing the laminated structure;
wherein optionally the adhesive (60) preferably has viscosity smaller than 1000 cps; and the adhesive (60) is an epoxy resin or an acrylic resin; and the cured adhesive has a volume shrinkage rate smaller than 1.1% and shore hardness ranging from 60D to 80D.

10. A three-dimensional display element, comprising a quantum dot complex (100), wherein the quantum dot complex (100) comprises:
a plurality of quantum dot units (10) sequentially laminated and bonded to each other in a thickness direction, each of the plurality of quantum dot units (10) comprising a transparent substrate (11), a first transparent conductive layer (12), a second transparent conductive layer (14), and a quantum dot layer (13), wherein each quantum dot unit (10) of the plurality of quantum dot units (10) comprises: a first protrusion formed on the first transparent conductive layer (12) and a second protrusion on the second transparent conductive layer (14), the first protrusion being configured to be connected to a first electrode, and the second protrusion being configured to be connected to a second electrode, and the first protrusion being offset from the second protrusion; and
a circuit board electrically connected to the first transparent conductive layer (12) and the second transparent conductive layer (14) of each quantum dot unit (10) by the first electrode and the second electrode, respectively,
wherein in each quantum dot unit (10), the first transparent conductive layer (12), the quantum dot layer (13) and the second transparent conductive layer (14) are located at a side of the transparent substrate (11) and sequentially arranged away from the transparent substrate (11);
wherein one of the first transparent conductive layer (12) and the second transparent conductive layer (14) is a P-type semiconductor, and another one of the first transparent conductive layer (12) and the second transparent conductive layer (14) is an N-type semiconductor; and
wherein the quantum dot layer (13), the first transparent conductive layer (12), and the second transparent conductive layer (14) of a quantum dot unit (10) where the first transparent conductive layer (12) is located or of a quantum dot unit (10) adjacent to the quantum dot unit (10) where the first transparent conductive layer (12) is located are formed as a PN junction,
wherein the quantum dot complex (100) has a surface formed as a laser incident surface; and in a lamination direction of the quantum dot units (10), the farther a quantum dot unit (10) is from the laser incident surface, the thicker the quantum dot unit (10) is.

11. The three-dimensional display element according to claim 10, wherein the quantum dot layer (13) has a thickness ranging from 0.05 µm to 10 µm; the transparent substrate (11) has a thickness ranging from 0.1 mm to 0.5 mm; an error on each of parallelism and planeness of each of an upper smooth surface and a lower smooth surface of the transparent substrate (11) is smaller than or equal to ± 2 µm; and a length a and a width b of the transparent substrate (11) satisfy 1 mm≤a≤500 mm, and 1 mm≤b≤500 mm; and/or
wherein a quantum dot layer (13) of each quantum dot unit (10) is configured to emit light in one color when being irradiated; or every three adjacent quantum dot units (10) are defined as a color adjustment group, quantum dot layers (13) of three quantum dot units (10) in each color adjustment group being configured to respectively emit red light, green light, and blue light when being irradiated.

## Patentansprüche

1. Verarbeitungsverfahren für ein dreidimensionales Anzeigeelement, wobei das Verarbeitungsverfahren umfasst:
sequentielles Bereitstellen (S1) einer ersten transparenten leitfähigen Schicht (12), Aufbringen einer Quantenpunktschicht (13) und Bereitstellen einer zweiten transparenten leitfähigen Schicht (14) auf einer Seite eines transparenten Substrats (11), um eine Quantenpunkteinheit (10) zu bilden, wobei das Verarbeiten der Quantenpunkteinheit (10) umfasst: Aufbringen einer ersten Fotolackschicht an einer Seite des transparenten Substrats (11); Belichten und Entwickeln, um einen Teil der ersten Fotolackschicht beizubehalten, um einen ersten Rückstandsabschnitt zu bilden; Galvanisieren der ersten transparenten leitfähigen Schicht (12) an einer Belichtungs- und Entwicklungsseite des transparenten Substrats (11); Abziehen des ersten Rückstandsabschnitts, um einen ersten Vorsprung an der ersten transparenten leitfähigen Schicht (12) zu bilden, wobei sich der erste Vorsprung an einer Seite einer Abziehregion befindet und dazu ausgelegt ist, mit einer ersten Elektrode verbunden zu werden; Aufbringen der Quantenpunktschicht (13) an einer Seite, an der sich die erste transparente leitfähige Schicht (12) befindet; Aufbringen einer zweiten Fotolackschicht; Belichten und Entwickeln, um einen Teil der zweiten Fotolackschicht beizubehalten, um einen zweiten Rückstandsabschnitt zu bilden, wobei der zweite Rückstandsabschnitt und der erste Rückstandsabschnitt nahe an einer Kante des transparenten Substrats (11) angeordnet sind; Galvanisieren der zweiten transparenten leitfähigen Schicht (14) an der Belichtungs- und Entwicklungsseite des transparenten Substrats (11); Abziehen des zweiten Rückstandsabschnitts, um einen zweiten Vorsprung auf der zweiten transparenten leitfähigen Schicht (14) zu bilden, wobei sich der zweite Vorsprung an einer Seite des zweiten Rückstandsabschnitts befindet und dazu ausgelegt ist, mit einer zweiten Elektrode verbunden zu werden, und wobei der erste Vorsprung vom zweiten Vorsprung versetzt ist;
Laminieren und Bonden (S2) einer Vielzahl von Quantenpunkteinheiten (10) in der Dickenrichtung der Vielzahl von Quantenpunkteinheiten (10) sequentiell;
Erhalten (S3) eines Quantenpunktkomplexes (100) durch Zuschneiden der gebondeten Quantenpunkteinheiten (10).
Bereitstellen der ersten Elektrode und der zweiten Elektrode außerhalb des Quantenpunktkomplexes (100), wobei die erste Elektrode elektrisch mit der ersten transparenten leitfähigen Schicht (12) jeder Quantenpunkteinheit (10) der Vielzahl von Quantenpunkteinheiten (10) verbunden ist und wobei die zweite Elektrode elektrisch mit der zweiten transparenten leitfähigen Schicht (14) jeder Quantenpunkteinheit (10) der Vielzahl von Quantenpunkteinheiten (10) verbunden ist;
Anbringen einer Leiterplatte an einer Seite des Quantenpunktkomplexes (100) und elektrisches Verbinden der Leiterplatte mit der ersten transparenten leitfähigen Schicht (12) und der zweiten transparenten leitfähigen Schicht (14) jeder Quantenpunkteinheit (10) der Vielzahl von Quantenpunkteinheiten (10) durch die erste Elektrode und die zweite Elektrode.

2. Verarbeitungsverfahren nach Anspruch 1, wobei das Laminieren und Bonden (S2) der Vielzahl von Quantenpunkteinheiten (10) in der Dickenrichtung der Vielzahl von Quantenpunkteinheiten (10) sequentiell umfasst:
Bereitstellen eines Abstandshalters (20) auf mindestens einer Seite jeder der Vielzahl von Quantenpunkteinheiten (10), wobei der Abstandshalter (20) ein transparentes Polymerbauteil, ein Harzbauteil, ein optisches Glasbauteil oder ein optisches Kristallbauteil ist;
Laminieren der Vielzahl von Quantenpunkteinheiten (10), um einen Laminierkörper zu bilden, wobei benachbarte Quantenpunkteinheiten der Vielzahl von Quantenpunkteinheiten (10) durch den Abstandshalter (20) voneinander beabstandet sind, um einen Spalt zur Aufnahme eines Klebstoffs (60) zu bilden;
Versiegeln von zwei gegenüberliegenden Seitenflächen des Laminierkörpers und Verwenden von zwei anderen gegenüberliegenden Seitenflächen des Laminierkörpers als Klebstoffeinleitungsfläche und Klebstoffablauffläche; und
Einspritzen des Klebstoffs (60), um den Klebstoff (60) von der Klebstoffeinleitungsfläche einzuleiten und den Spalt zu füllen, um eine Schicht aus ausgehärtetem Klebstoff mit dem Abstandshalter (20) zwischen den benachbarten Quantenpunkteinheiten (10) zu bilden.

3. Verarbeitungsverfahren nach Anspruch 2, wobei der Abstandshalter (20) eine Höhe von 1 µm bis 500 µm aufweist;
ein Abstand zwischen benachbarten Abstandshaltern (20) im Bereich von 0,1 mm bis 5 mm liegt; und
eine Abweichung bei den Höhen einer Vielzahl von Abstandshaltern (20) kleiner oder gleich 2 µm ist.

4. Verarbeitungsverfahren nach Anspruch 2 oder 3, wobei ein Abstand zwischen benachbarten Abstandshaltern (20) von 5 µm bis 20 mm beträgt;
der Abstandshalter (20) auswählbar ist aus einem von Siliciumdioxid-Mikrokügelchen, Polystyrol-Mikrokügelchen und Polymethylmethacrylat-Mikrokügelchen; und
der Abstandshalter (20) einen Kugeldurchmesser von 1 µm bis 200 µm aufweist, wobei die Abweichung in der Konstanz des Durchmessers kleiner als 10 % ist.

5. Verarbeitungsverfahren nach einem der Ansprüche 2 bis 4, weiter umfassend vor dem Versiegeln der beiden gegenüberliegenden Seitenflächen des Laminierkörpers oder dem Härten des Klebstoffs (60):
Einstellen von Parallelität und Planheit des Laminierkörpers, um eine Abweichung bei der Parallelität und Planheit jeweils innerhalb von ± 5 µm zu kontrollieren.

6. Verarbeitungsverfahren nach einem der Ansprüche 2 bis 5, wobei der Laminierkörper unter Verwendung eines flüssigen oder eines festen Dichtmittels abgedichtet wird, wobei das flüssige Dichtmittel ein Epoxidharz oder ein Acrylharz ist und das feste Dichtmittel eine Gummiplatte oder ein Silikonklebstoff ist,
wobei das flüssige Dichtmittel eine Viskosität von mehr als 20000 cps aufweist und durch Normaltemperatur-Natürlichhärtung, Wärmehärtung oder Ultraviolettbestrahlungshärtung verfestigt wird; und
wobei das verfestigte flüssige Dichtmittel eine Shore-Härte im Bereich von 20 A bis 70 A aufweist.

7. Verarbeitungsverfahren nach einem der Ansprüche 2 bis 6, wobei der Klebstoff (60) vor dem Einspritzen entlüftet wird;
der Klebstoff (60) eine Viskosität von weniger als 500 cP aufweist;
der Klebstoff (60) ein Epoxidharz oder ein Acrylharz ist; und
der ausgehärtete Klebstoff eine Volumenschrumpfrate von weniger als 1,1 %, eine Shore-Härte im Bereich von 60 D bis 80 D und einen Brechungsindex aufweist, der mit dem Brechungsindex des transparenten Substrats (11) übereinstimmt.

8. Verarbeitungsverfahren nach einem der Ansprüche 2 bis 7, wobei der Klebstoff (60) durch eines von einem ersten Schwerkraftspritzen, einem zweiten Schwerkraftspritzen, einem ersten Druckspritzen, einem zweiten Druckspritzen und einem Vakuumspritzen eingespritzt wird,
wobei das erste Schwerkraftspritzen umfasst:
Platzieren der Klebstoffeinleitungsfläche des Laminierkörpers in ein Klebstoffbecken (51) einer Schwerkraft-Klebstoffzuführeinrichtung;
dichtendes Verbinden der Schwerkraft-Klebstoffzuführeinrichtung und der Klebstoffeinleitungsfläche durch ein Dichtmaterial oder ein Dichtwerkzeug;
Platzieren des Laminierkörpers und der Klebstoffzuführeinrichtung in eine Vakuumkammer (52) einer Vakuumanlage;
Füllen des Spalts mit dem Klebstoff (60) durch die Schwerkraft des Klebstoffs (60) und eine Kapillare des Klebstoffs (60);
Schließen der Vakuumanlage in Reaktion auf die Beobachtung, dass der Klebstoff (60) gleichmäßig an allen Positionen der Klebstoffablauffläche austritt; und
Vervollständigen des Einspritzens des Klebstoffs (60);
wobei das zweite Schwerkraftspritzen umfasst:
Platzieren der Klebstoffeinleitungsfläche des Laminierkörpers in ein Klebstoffbecken (51) einer Schwerkraft-Klebstoffzuführeinrichtung;
dichtendes Verbinden der Schwerkraft-Klebstoffzuführeinrichtung und der Klebstoffeinleitungsfläche durch ein Dichtmaterial oder ein Dichtwerkzeug;
Verbinden einer Vakuumanlage an der Klebstoffablauffläche, um die gesamte Klebstoffablauffläche des Laminierkörpers zu umhüllen;
Abschirmen der Klebstoffablauffläche von einer äußeren Umgebung durch das Dichtmaterial oder das Dichtwerkzeug;
Einstellen eines absoluten Vakuumgrads der Vakuumanlage unter 10 kPa;
Schließen der Vakuumanlage in Reaktion auf die Beobachtung, dass der Klebstoff (60) gleichmäßig an allen Positionen der Klebstoffablauffläche austritt; und
Vervollständigen des Einspritzens des Klebstoffs (60);
wobei das erste Druckspritzen umfasst:
Platzieren der Klebstoffeinleitungsfläche des Laminierkörpers in einem Klebstoff einer Druck-Klebstoffzuführeinrichtung;
dichtendes Verbinden der Druck-Klebstoffzuführeinrichtung und der Klebstoffeinleitungsfläche durch ein Dichtmaterial oder ein Dichtwerkzeug;
Ausüben eines mechanischen Drucks auf den Klebstoff (60), um den Spalt mit dem Klebstoff (60) zu füllen;
Überwachen eines Einstelldrucks durch einen Drucksensor, der an der Klebstoffzuführeinrichtung montiert ist, um eine Klebstoffzufuhrgeschwindigkeit zu steuern;
Schließen einer Druckausübevorrichtung in Reaktion auf die Beobachtung, dass der Klebstoff (60) gleichmäßig an allen Positionen der Klebstoffablauffläche austritt; und
Vervollständigen des Einspritzens des Klebstoffs (60);
wobei das zweite Druckspritzen umfasst:
Platzieren der Klebstoffeinleitungsfläche des Laminierkörpers in einem Klebstoff einer Druck-Klebstoffzuführeinrichtung;
dichtendes Verbinden der Druck-Klebstoffzuführeinrichtung und der Klebstoffeinleitungsfläche durch ein Dichtmaterial oder ein Dichtwerkzeug;
Ausüben eines atmosphärischen Drucks, damit der Spalt mit dem Klebstoff (60) gefüllt werden kann;
Überwachen eines Einstellluftdrucks durch ein Gasströmungsventil, das an der Druck-Klebstoffzuführeinrichtung montiert ist, um eine Klebstoffzufuhrgeschwindigkeit zu steuern;
Schließen einer Druckausübevorrichtung, wenn beobachtet wird, dass der Klebstoff gleichmäßig an allen Positionen der Klebstoffablauffläche austritt; und
Vervollständigen des Einspritzens des Klebstoffs (60); und
wobei das Vakuumspritzen umfasst:
Eintauchen der Klebstoffeinleitungsfläche des Laminierkörpers in ein Klebstoffbecken (51), das den Klebstoff (60) enthält, um die gesamte Klebstoffeinleitungsfläche durch den Klebstoff (60) flüssigdicht zu versiegeln;
Verbinden einer Vakuumanlage an der Klebstoffablauffläche, um die gesamte Klebstoffablauffläche des Laminierkörpers durch die Vakuumanlage zu umhüllen;
Abschirmen der Klebstoffablauffläche von einer äußeren Umgebung durch ein Dichtmaterial oder ein Dichtwerkzeug;
Einstellen eines absoluten Vakuumgrads der Vakuumanlage unter 10 kPa;
Schließen der Vakuumanlage, wenn beobachtet wird, dass der Klebstoff (60) gleichmäßig an allen Positionen der Klebstoffablauffläche austritt; und
Vervollständigen des Einspritzens des Klebstoffs (60).

9. Verarbeitungsverfahren nach einem der Ansprüche 1 bis 8, wobei das Laminieren und Bonden (S2) der Vielzahl von Quantenpunkteinheiten (10) in der Dickenrichtung der Vielzahl von Quantenpunkteinheiten (10) sequentiell umfasst:
Platzieren, nachdem eine erste Quantenpunkteinheit der Vielzahl von Quantenpunkteinheiten (10) mit dem Klebstoff (60) beschichtet wurde, einer zweiten Quantenpunkteinheit der Vielzahl von Quantenpunkteinheiten (10) auf dem Klebstoff (60) zum Bonden, Wiederholen dieses Vorgangs, um eine laminierte Struktur zu bilden; und
Einstellen der Parallelität und Ebenheit der laminierten Struktur vor dem Aushärten der laminierten Struktur;
wobei wahlweise der Klebstoff (60) vorzugsweise eine Viskosität unter 1000 cps hat; der Klebstoff (60) ein Epoxidharz oder ein Acrylharz ist; und der ausgehärtete Klebstoff eine Volumenschrumpfrate unter 1,1 % und eine Shore-Härte zwischen 60D und 80D hat.

10. Dreidimensionales Anzeigeelement, umfassend einen Quantenpunktkomplex (100), wobei der Quantenpunktkomplex (100) umfasst:
eine Vielzahl von Quantenpunkteinheiten (10), die in einer Dickenrichtung sequentiell laminiert und miteinander gebondet sind, wobei jede der Vielzahl von Quantenpunkteinheiten (10) ein transparentes Substrat (11), eine erste transparente leitfähige Schicht (12), eine zweite transparente leitfähige Schicht (14) und eine Quantenpunktschicht (13) umfasst, wobei jede Quantenpunkteinheit (10) der Vielzahl von Quantenpunkteinheiten (10) umfasst: einen ersten Vorsprung, der auf der ersten transparenten leitfähigen Schicht (12) gebildet ist, und einen zweiten Vorsprung auf der zweiten transparenten leitfähigen Schicht (14), wobei der erste Vorsprung dazu konfiguriert ist, mit einer ersten Elektrode verbunden zu werden, und der zweite Vorsprung dazu konfiguriert ist, mit einer zweiten Elektrode verbunden zu werden, und wobei der erste Vorsprung zum zweiten Vorsprung versetzt ist;
eine Leiterplatte, die mit der ersten transparenten leitfähigen Schicht (12) und der zweiten transparenten leitfähigen Schicht (14) jeder Quantenpunkteinheit (10) jeweils durch die erste Elektrode und die zweite Elektrode elektrisch verbunden ist,
wobei sich in jeder Quantenpunkteinheit (10) die erste transparente leitfähige Schicht (12), die Quantenpunktschicht (13) und die zweite transparente leitfähige Schicht (14) auf einer Seite des transparenten Substrats (11) befinden und sequentiell vom transparenten Substrat (11) weg angeordnet sind;
wobei eine der ersten transparenten leitfähigen Schicht (12) und der zweiten transparenten leitfähigen Schicht (14) ein P-Typ-Halbleiter ist und die andere der ersten transparenten leitfähigen Schicht (12) und der zweiten transparenten leitfähigen Schicht (14) ein N-Typ-Halbleiter ist; und
wobei die Quantenpunktschicht (13), die erste transparente leitende Schicht (12) und die zweite transparente leitende Schicht (14) einer Quantenpunkteinheit (10), in der sich die erste transparente leitende Schicht (12) befindet, oder einer Quantenpunkteinheit (10), die an die Quantenpunkteinheit (10) angrenzt, in der sich die erste transparente leitende Schicht (12) befindet, als PN-Übergang ausgebildet sind,
wobei der Quantenpunktkomplex (100) eine Oberfläche aufweist, die als eine Laser-Einfallsfläche ausgebildet ist; und in einer Laminierungsrichtung der Quantenpunkteinheiten (10), je weiter eine Quantenpunkteinheit (10) von der Laser-Einfallsfläche entfernt ist, desto dicker ist die Quantenpunkteinheit (10).

11. Dreidimensionales Anzeigeelement nach Anspruch 10, wobei die Quantenpunktschicht (13) eine Dicke im Bereich von 0,05 µm bis 10 µm aufweist; das transparente Substrat (11) eine Dicke im Bereich von 0,1 mm bis 0,5 mm aufweist; eine Abweichung bei Parallelität und Planheit sowohl einer oberen glatten Fläche als auch einer unteren glatten Fläche des transparenten Substrats (11) kleiner oder gleich ± 2 µm ist; und eine Länge a und eine Breite b des transparenten Substrats (11) 1 mm ≤ a ≤ 500 mm und 1 mm ≤ b ≤ 500 mm erfüllen; und/oder
eine Quantenpunktschicht (13) jeder Quantenpunkteinheit (10) ist konfiguriert, Licht in einer Farbe abzustrahlen, wenn sie bestrahlt wird; oder jeweils drei benachbarte Quantenpunkteinheiten (10) als Farbeinstellgruppe definiert werden, wobei die Quantenpunktschichten (13) der drei Quantenpunkteinheiten (10) in jeder Farbeinstellgruppe konfiguriert sind, bei Bestrahlung jeweils rotes Licht, grünes Licht und blaues Licht abzustrahlen, wenn sie bestrahlt werden.

## Revendications

1. Une méthode de traitement pour un élément d'affichage tridimensionnel, ladite méthode de traitement comprenant :
la fourniture séquentielle (S1) d'une première couche conductrice transparente (12), le dépôt d'une couche de points quantiques (13) et la fourniture d'une deuxième couche conductrice transparente (14) sur un côté d'un substrat transparent (11) pour former une unité de points quantiques (10),
dans laquelle le traitement de l'unité de points quantiques (10) comprend :
le dépôt d'une première couche de résine photosensible sur un côté du substrat transparent (11);
l'exposition et le développement pour conserver une partie de la première couche de résine photosensible afin de former une première partie résiduelle ;
le dépôt de la première couche conductrice transparente (12) sur le côté d'exposition et de développement du substrat transparent (11) ;
le décollage de la première partie résiduelle pour former une première saillie sur la première couche conductrice transparente (12), ladite première saillie étant située sur un côté d'une région de décollage et étant configurée pour être connectée à une première électrode ;
le dépôt de la couche de points quantiques (13) sur le côté où se trouve la première couche conductrice transparente (12) ;
le dépôt d'une deuxième couche de résine photosensible ;
l'exposition et le développement pour conserver une partie de la deuxième couche de résine photosensible afin de former une deuxième partie résiduelle, ladite deuxième partie résiduelle et la première partie résiduelle étant disposées à proximité d'un bord du substrat transparent (11) ;
le dépôt de la deuxième couche conductrice transparente (14) sur le côté d'exposition et de développement du substrat transparent (11) ;
le décollage de la deuxième partie résiduelle pour former une deuxième saillie sur la deuxième couche conductrice transparente (14), ladite deuxième saillie étant située sur un côté de la deuxième partie résiduelle et étant configurée pour être connectée à une deuxième électrode, et la première saillie étant décalée par rapport à la deuxième saillie ;
le stratification et le collage séquentiels (S2) d'une pluralité d'unités de points quantiques (10) dans la direction de l'épaisseur ;
l'obtention (S3) d'un complexe de points quantiques (100) par le rognage des unités de points quantiques (10) collées ;
la fourniture de la première électrode et de la deuxième électrode à l'extérieur du complexe de points quantiques (100), la première électrode étant électriquement connectée à la première couche conductrice transparente (12) de chaque unité de points quantiques (10) de la pluralité d'unités de points quantiques (10), et la deuxième électrode étant électriquement connectée à la deuxième couche conductrice transparente (14) de chaque unité de points quantiques (10) de la pluralité d'unités de points quantiques (10) ; et
la fixation d'une carte de circuit imprimé sur un côté du complexe de points quantiques (100), et la connexion électrique de la carte de circuit imprimé à la première couche conductrice transparente (12) et à la deuxième couche conductrice transparente (14) de chaque unité de points quantiques (10) de la pluralité d'unités de points quantiques (10) par l'intermédiaire de la première électrode et de la deuxième électrode.

2. La méthode de traitement selon la revendication 1, dans laquelle ladite stratification et collage séquentiels (S2) de la pluralité d'unités de points quantiques (10) dans la direction de l'épaisseur comprennent :
la fourniture d'un espaceur (20) sur au moins un côté de chacune des unités de la pluralité d'unités de points quantiques (10), ledit espaceur (20) étant un élément en matériau polymère transparent, un élément en résine, un élément en verre optique ou un élément en cristal optique ;
la stratification de la pluralité d'unités de points quantiques (10) pour former un corps stratifié, les unités adjacentes de la pluralité d'unités de points quantiques (10) étant espacées les unes des autres par l'espaceur (20) pour former un interstice destiné à recevoir un adhésif (60) ;
le scellement de deux surfaces latérales opposées du corps stratifié, et l'utilisation des deux autres surfaces latérales opposées du corps stratifié comme surface d'introduction de l'adhésif et surface d'éjection de l'adhésif ; et
l'injection de l'adhésif (60) pour introduire l'adhésif (60) depuis la surface d'introduction de l'adhésif et remplir l'interstice, afin de former une couche d'adhésif durci contenant l'espaceur (20) entre les unités de points quantiques (10) adjacentes.

3. La méthode de traitement selon la revendication 2, dans laquelle l'espaceur (20) présente une hauteur comprise entre 1 µm et 500 µm ;
la distance entre des espaceurs (20) adjacents est comprise entre 0,1 mm et 5 mm ; et
l'erreur sur les hauteurs d'une pluralité d'espaceurs (20) est inférieure ou égale à 2 µm.

4. La méthode de traitement selon la revendication 2 ou 3, dans laquelle la distance entre des espaceurs (20) adjacents est comprise entre 5 µm et 20 mm ;
l'espaceur (20) peut être choisi parmi une microsphère de dioxyde de silicium, une microsphère de polystyrène et une microsphère de polyméthacrylate de méthyle ; et
l'espaceur (20) présente un diamètre sphérique compris entre 1 µm et 200 µm, l'erreur sur la consistance du diamètre étant inférieure à 10 %.

5. La méthode de traitement selon l'une quelconque des revendications 2 à 4, comprenant en outre, avant le scellement des deux surfaces latérales opposées du corps stratifié ou le durcissement de l'adhésif (60) :
l'ajustement du parallélisme et de la planéité du corps stratifié pour contrôler l'erreur sur le parallélisme et la planéité à ± 5 µm près.

6. La méthode de traitement selon l'une quelconque des revendications 2 à 5, dans laquelle le corps stratifié est scellé à l'aide d'un produit d'étanchéité liquide ou d'un produit d'étanchéité solide, le produit d'étanchéité liquide étant une résine époxy ou une résine acrylique, et le produit d'étanchéité solide étant une plaque de caoutchouc ou un adhésif silicone,
dans lequel le produit d'étanchéité liquide présente une viscosité supérieure à 20 000 cps et est durci par durcissement naturel à température ambiante, durcissement par chauffage ou durcissement par irradiation ultraviolette ; et
dans lequel le produit d'étanchéité liquide durci présente une dureté Shore comprise entre 20 A et 70 A.

7. La méthode de traitement selon l'une quelconque des revendications 2 à 6, dans laquelle l'adhésif (60) est dégazé avant d'être injecté ;
l'adhésif (60) présentant une viscosité inférieure à 500 cps ;
l'adhésif (60) étant une résine époxy ou une résine acrylique ; et
l'adhésif durci présentant un taux de retrait volumique inférieur à 1,1 %, une dureté Shore comprise entre 60 D et 80 D, et un indice de réfraction identique à celui du substrat transparent (11).

8. La méthode de traitement selon l'une quelconque des revendications 2 à 7, dans laquelle l'adhésif (60) est injecté par l'une parmi une première injection par gravité, une seconde injection par gravité, une première injection sous pression, une seconde injection sous pression et une injection sous vide,
dans lequel la première injection par gravité comprend :
la disposition de la surface d'introduction de l'adhésif du corps stratifié dans un bain d'adhésif (51) d'un dispositif d'alimentation en adhésif par gravité ;
la connexion étanche du dispositif d'alimentation en adhésif par gravité et de la surface d'introduction de l'adhésif au moyen d'un matériau d'étanchéité ou d'un outil d'étanchéité ;
la disposition du corps stratifié et du dispositif d'alimentation en adhésif dans une chambre à vide (52) d'un dispositif de vide ;
le remplissage de l'interstice avec l'adhésif (60) par l'intermédiaire de la gravité de l'adhésif (60) et de la capillarité de l'adhésif (60) ;
la fermeture du dispositif de vide en réponse à l'observation que l'adhésif (60) s'infiltre uniformément en tous points de la surface d'éjection de l'adhésif ; et
l'achèvement de l'injection de l'adhésif (60) ;
dans lequel la seconde injection par gravité comprend :
la disposition de la surface d'introduction de l'adhésif du corps stratifié dans un bain d'adhésif (51) d'un dispositif d'alimentation en adhésif par gravité ;
la connexion étanche du dispositif d'alimentation en adhésif par gravité et de la surface d'introduction de l'adhésif au moyen d'un matériau d'étanchéité ou d'un outil d'étanchéité ;
la connexion d'un dispositif de vide au niveau de la surface d'éjection de l'adhésif pour envelopper la totalité de la surface d'éjection de l'adhésif du corps stratifié ;
l'isolation de la surface d'éjection de l'adhésif d'un environnement externe au moyen du matériau d'étanchéité ou de l'outil d'étanchéité ;
la réglage du degré de vide absolu du dispositif de vide à une valeur inférieure à 10 kPa ; la fermeture du dispositif de vide en réponse à l'observation que l'adhésif (60) s'infiltre uniformément en tous points de la surface d'éjection de l'adhésif ; et
l'achèvement de l'injection de l'adhésif (60) ;
dans lequel la première injection sous pression comprend :
la disposition de la surface d'introduction de l'adhésif du corps stratifié dans un adhésif d'un dispositif d'alimentation en adhésif sous pression ;
la connexion étanche du dispositif d'alimentation en adhésif sous pression et de la surface d'introduction de l'adhésif au moyen d'un matériau d'étanchéité ou d'un outil d'étanchéité ;
l'application d'une pression mécanique à l'adhésif (60) pour permettre à l'interstice d'être rempli de l'adhésif (60) ;
la surveillance de la pression de réglage par un capteur de pression monté sur le dispositif d'alimentation en adhésif sous pression pour contrôler la vitesse d'alimentation en adhésif ;
la fermeture d'un dispositif d'application de pression en réponse à l'observation que l'adhésif (60) s'infiltre uniformément en tous points de la surface d'éjection de l'adhésif ; et l'achèvement de l'injection de l'adhésif (60) ;
dans lequel la seconde injection sous pression comprend :
la disposition de la surface d'introduction de l'adhésif du corps stratifié dans un adhésif d'un dispositif d'alimentation en adhésif sous pression ;
la connexion étanche du dispositif d'alimentation en adhésif sous pression et de la surface d'introduction de l'adhésif au moyen d'un matériau d'étanchéité ou d'un outil d'étanchéité ;
l'application d'une pression atmosphérique pour permettre à l'interstice d'être rempli de l'adhésif (60) ;
la surveillance de la pression d'air de réglage par une vanne de débit de gaz montée sur le dispositif d'alimentation en adhésif sous pression pour contrôler la vitesse d'alimentation en adhésif ;
la fermeture d'un dispositif d'application de pression en réponse à l'observation que l'adhésif s'infiltre uniformément en tous points de la surface d'éjection de l'adhésif ; et
l'achèvement de l'injection de l'adhésif (60) ; et
dans lequel l'injection sous vide comprend :
l'immersion de la surface d'introduction de l'adhésif du corps stratifié dans un bain d'adhésif (51) contenant l'adhésif (60) pour sceller de manière liquide la totalité de la surface d'introduction de l'adhésif par l'adhésif (60) ;
la connexion d'un dispositif de vide au niveau de la surface d'éjection de l'adhésif pour envelopper la totalité de la surface d'éjection de l'adhésif du corps stratifié par le dispositif de vide ;
l'isolation de la surface d'éjection de l'adhésif d'un environnement externe au moyen d'un matériau d'étanchéité ou d'un outil d'étanchéité ;
la réglage du degré de vide absolu du dispositif de vide à une valeur inférieure à 10 kPa ;
la fermeture du dispositif de vide en réponse à l'observation que l'adhésif (60) s'infiltre uniformément en tous points de la surface d'éjection de l'adhésif ; et
l'achèvement de l'injection de l'adhésif (60).

9. La méthode de traitement selon l'une quelconque des revendications 1 à 8, dans laquelle ladite stratification et collage séquentiels (S2) de la pluralité d'unités de points quantiques (10) dans la direction de l'épaisseur comprennent :
la disposition, après qu'une première unité de la pluralité d'unités de points quantiques (10) a été revêtue de l'adhésif (60), d'une seconde unité de la pluralité d'unités de points quantiques (10) sur l'adhésif (60) pour le collage, et la répétition de ce processus pour former une structure stratifiée ; et
l'ajustement du parallélisme et de la planéité de la structure stratifiée avant le durcissement de la structure stratifiée ;
dans laquelle, facultativement, l'adhésif (60) présente de préférence une viscosité inférieure à 1000 cps ; et l'adhésif (60) est une résine époxy ou une résine acrylique ; et l'adhésif durci présente un taux de retrait volumique inférieur à 1,1 % et une dureté Shore comprise entre 60 D et 80 D.

10. Un élément d'affichage tridimensionnel, comprenant un complexe de points quantiques (100), dans lequel le complexe de points quantiques (100) comprend :
une pluralité d'unités de points quantiques (10) stratifiées et collées séquentiellement les unes aux autres dans la direction de l'épaisseur, chaque unité de la pluralité d'unités de points quantiques (10) comprenant un substrat transparent (11), une première couche conductrice transparente (12), une deuxième couche conductrice transparente (14) et une couche de points quantiques (13), chaque unité de points quantiques (10) de la pluralité d'unités de points quantiques (10) comprenant : une première saillie formée sur la première couche conductrice transparente (12) et une deuxième saillie sur la deuxième couche conductrice transparente (14), la première saillie étant configurée pour être connectée à une première électrode, et la deuxième saillie étant configurée pour être connectée à une deuxième électrode, et la première saillie étant décalée par rapport à la deuxième saillie ; et
une carte de circuit imprimé électriquement connectée à la première couche conductrice transparente (12) et à la deuxième couche conductrice transparente (14) de chaque unité de points quantiques (10) par l'intermédiaire de la première électrode et de la deuxième électrode, respectivement,
dans laquelle, dans chaque unité de points quantiques (10), la première couche conductrice transparente (12), la couche de points quantiques (13) et la deuxième couche conductrice transparente (14) sont situées sur un côté du substrat transparent (11) et disposées séquentiellement en s'éloignant du substrat transparent (11) ;
dans laquelle l'une de la première couche conductrice transparente (12) et de la deuxième couche conductrice transparente (14) est un semi-conducteur de type P, et l'autre de la première couche conductrice transparente (12) et de la deuxième couche conductrice transparente (14) est un semi-conducteur de type N ; et
dans laquelle la couche de points quantiques (13), la première couche conductrice transparente (12) et la deuxième couche conductrice transparente (14) d'une unité de points quantiques (10) dans laquelle se trouve la première couche conductrice transparente (12) ou d'une unité de points quantiques (10) adjacente à l'unité de points quantiques (10) dans laquelle se trouve la première couche conductrice transparente (12) sont formées en tant que jonction PN,
dans laquelle le complexe de points quantiques (100) présente une surface formée en tant que surface d'incidence laser ; et dans la direction de stratification des unités de points quantiques (10), plus une unité de points quantiques (10) est éloignée de la surface d'incidence laser, plus l'unité de points quantiques (10) est épaisse.

11. L'élément d'affichage tridimensionnel selon la revendication 10, dans lequel la couche de points quantiques (13) présente une épaisseur comprise entre 0,05 µm et 10 µm ; le substrat transparent (11) présente une épaisseur comprise entre 0,1 mm et 0,5 mm ; l'erreur sur le parallélisme et la planéité de chacune des surfaces lisses supérieure et inférieure du substrat transparent (11) est inférieure ou égale à ± 2 µm ; et une longueur a et une largeur b du substrat transparent (11) satisfont 1 mm ≤ a ≤ 500 mm et 1 mm ≤ b ≤ 500 mm ; et/ou
dans laquelle une couche de points quantiques (13) de chaque unité de points quantiques (10) est configurée pour émettre de la lumière d'une seule couleur lorsqu'elle est irradiée ; ou toutes les trois unités de points quantiques (10) adjacentes sont définie comme un groupe de coloration, les couches de points quantiques (13) des trois unités de points quantiques (10) dans chaque groupe de coloration étant configurées pour émettre respectivement de la lumière rouge, de la lumière verte et de la lumière bleue lorsqu'elles sont irradiées.
